# EUROPEAN PATENT SPECIFICATION

(11) **EP 2 548 999 B1**
(45) Date of publication and mention of the grant of the patent: **02.05.2018**
(21) Application number: 11756257.9
(22) Date of filing: 14.03.2011
(51) Int. Cl.: C30B 9/10, C30B 29/40, C30B 19/02, C30B 19/12

(54) **METHOD OF MANUFACTURING A GALLIUM NITRIDE CRYSTAL**
VERFAHREN ZUR HERSTELLUNG EINES GALLIUMNITRIDKRISTALLS
PROCÉDÉ DE PRODUCTION D'UN CRISTAL DE NITRURE DE GALLIUM

(30) Priority: 16.02.2011 JP 2011031397; 15.03.2010 JP 2010058276
(43) Date of publication of application: 23.01.2013
(73) Proprietor: Ricoh Company, Limited, Tokyo 143-8555 (JP)
(72) Inventor: NAMBU, Hiroshi, Tokyo 143-8555 (JP); IWATA, Hirokazu, Tokyo 143-8555 (JP); SATOH, Takashi, Tokyo 143-8555 (JP)
(74) Representative: J A Kemp
(86) International application number: PCT/JP2011/055964
(87) International publication number: WO 2011/115072

(56) References cited:
- EP-A1- 1 916 321
- EP-A1- 2 402 486
- EP-A1- 2 423 355
- JP-A- 2003 292 400
- JP-A- 2008 094 704
- JP-A- 2008 222 453
- BOCKOWSKI ET AL: "Platelets and needles: Two habits of pressure-grown GaN crystals", JOURNAL OF CRYSTAL GROWTH, ELSEVIER, AMSTERDAM, NL, vol. 305, no. 2, 4 July 2007 (2007-07-04), pages 414-420, XP022143205, ISSN: 0022-0248, DOI: 10.1016/J.JCRYSGRO.2007.03.027
- MURAKAMI ET AL.: '14a-A-8 Na Flux-ho ni yoru Rod-jo GaN Tanekessho o Mochiita Bulk Seicho' DAI 71 KAI EXTENDED ABSTRACTS; THE JAPAN SOCIETY OF APPLIED PHYSICS 2010, pages 15 - 114, XP008168043

## Description

### Field

The present invention relates to a method of manufacturing a gallium nitride crystal.

### Background

Semiconductor materials based on gallium nitride (GaN) are used for blue color LED (light-emitting diode) or white color LED, and a semiconductor device such as semiconductor laser (also called "LD: Laser Diode"). The white color LED is used for illumination purpose or back lighting of cell phones, LC (Liquid Crystal) display or the like. The blue color LED is used for traffic lights or other illumination purpose and so on. On the other hand, blue-violet semiconductor laser is used as light sources of Blu-ray discs.

Presently, with only a few exceptions, most of semiconductor devices based on gallium nitride (GaN) used as light sources of UV or violet-blue-green color are manufactured by using MO-CVD (Metalorganic Chemical Vapor Deposition) method or MBE (Molecular Beam Epitaxy) method to grow crystal on sapphire or SiC substrate. There are problems in a case that sapphire or SiC is used as substrate. Crystal defects increases because of the significant difference of thermal expansion coefficient or lattice constant between the substrate and the group 13 nitride. Such a defect affects device properties. For example, it becomes harder to elongate the lifetime of emitting device. And, the operating power may increase. In order to address these problems, it is the most preferable way to use a gallium nitride substrate which is made of the same material as crystal to be grown on the substrate.

Presently, free-standing GaN substrates are manufactured in such a manner that a thick gallium nitride crystal is grown on a hetero-substrate such as sapphire substrate or GaAs substrate by HVPE (Hydride Vapor Phase Epitaxy) with employing a method to reduce the dislocation density such as ELO (Epitaxial Lateral Overgrowth), advance-DEEP method, and VAS method, and then the thick film of gallium nitride is separated from the hetero-substrate. The gallium nitride substrate manufactured as such has a dislocation density reduced to the order of 10⁶ cm⁻², and allows a size up to 2 inches in practical use mainly for laser device purpose. Recently, there is a further need for much larger diameter of substrate up to 4 inches or 6 inches for electronic devices, or cost saving of white color LEDs.

However, warpage or cracks which may be induced by the difference of the thermal expansion coefficient between the hetero-substrate and the gallium nitride hinders to enlarge the diameter of substrate.

On the other hand, as one of liquid phase methods to realize the gallium nitride substrate, many efforts have been made for developing a flux method in which the gallium nitride crystal is formed by dissolving the nitrogen from a gaseous phase into a molten mixture of group 13 metal and alkali metal.

In the flux method, a molten mixture containing the alkali metal such as sodium (Na) and potassium (K) and the group 13 metal such as gallium (Ga) is heated to about 600 to 900 degrees Celsius under an atmosphere where the nitrogen pressure is 10 MPa or less. Thus, the nitrogen is dissolved from the gaseous phase and reacts with the group 13 metal in the molten mixture to form the group 13 nitride crystal. The flux method allows a crystal growth with a lower temperature and lower pressure in comparison with other liquid phase methods. The crystal formed by the flux method has a low dislocation density advantageously lower than 10⁶ cm⁻².

In Chemistry of Materials Vol. 9 (1997) 413-416, there is a report that gallium nitride crystal is formed under conditions that sodium azide (NaN₃) and metal Ga which are used as source materials are put and sealed in a reactor vessel made of stainless matereial (as for sizes inside of the vessel, inner diameter is 7.5 mm, length is 100 mm) under a nitrogen atmosphere, and the reactor vessel is retained at 600 to 800 degrees Celsius for 24 to 100 hours.

In the Journal of Crystal Growth Vol. 305 (2007) 414-420, the growth of GaN needles by a high-pressure solution method is investigated and their use as seed crystals for HVPE growth is described.

Japanese Patent Application Laid-open No. 2008-94704 discloses a method of manufacturing a column-like crystal of gallium nitride by using a needle-like crystal of aluminum nitride (AlN) as seed crystal in order to provide a large crystal of gallium nitride. Japanese Patent Application Laid-open No. 2006-045047 discloses a method of manufacturing a needle-like crystal of aluminum nitride which becomes a seed crystal. Japanese Patent Application Laid-open No. 2008-222453 discloses a relationship between the nitrogen gas pressure and the melt solution temperature for gallium nitride crystal growth from a melt solution.

According to the present inventors' experience, a practical length of a needle-like crystal to be used as a seed crystal in a flux method requires approximately 9 mm or more in view of the seed crystal retaining or the like. Furthermore, a diameter (a maximum length in a cross section orthogonal to a longitudinal direction) of the seed crystal requires 100 µm or more, since if it is too small, the handling becomes difficult, and it may be broken in the course of putting the source materials, or in the course of installing the seed crystal.

### Summary

### Technical Problem

However, in a case that gallium nitride crystal is formed from aluminum nitride as seed crystal, however, the difference of lattice constant between aluminum nitride and gallium nitride may cause dislocations due to the lattice mismatch. Since thermal expansion coefficient is also different between aluminum nitride and gallium nitride, thermal stress may cause new dislocations or even cracks, in the course of cooling from a crystal growth temperature to a room temperature.

Therefore, as a seed crystal to grow a high quality gallium nitride crystal with low dislocation density, it is preferable to use gallium nitride crystal which has the same lattice constant or the same thermal expansion coefficient with the target crystal. However, it is difficult to grow a needle-like crystal of gallium nitride by the method disclosed in Japanese Patent Application Laid-open No. 2006-045047. Therefore, a needle-like crystal of gallium nitride having a length of approximately 9 mm or more and a diameter of 100 µm or more has not been realized.

Therefore, it has not been possible to manufacture a high quality gallium nitride crystal (bulk crystal) having a dislocation density of 10⁶ cm⁻² or less by using such a needle-like crystal of gallium nitride as a seed crystal.

The present invention has been accomplished in view of the aforementioned problems, and aims to manufacture a large sized bulk crystal from which a practical size of a crystal substrate can be cut out.

### Solution to Problem

In order to solve the aforementioned problems and accomplish the aforementioned aims, the present invention provides a method of manufacturing a gallium nitride crystal as defined in the appended claims.

### Advantageous Effects of Invention

According to the present invention, a gallium nitride crystal having a length L of the c-axis of 9 mm or more, and a ratio L/d of 7 or more of the length L of the c-axis to the crystal diameter d in the cross section orthogonal to the c-axis can be produced. Therefore, by enlarging this elongated needle-like crystal, a bulk crystal with a large volume can be produced, and a large sized bulk crystal can be produced which allows to cut out a practical size of crystal substrate.

### Brief Description of Drawings

FIG. 1 is a cross section schematically illustrating a crystal growth apparatus to manufacture a seed crystal, in an embodiment of the present invention.
FIG. 2 is a schematic view illustrating the c-axis and a c-plane of a needle-like crystal of group 13 nitride crystal.
FIG. 3 is a schematic view illustrating a c-plane.
FIG. 4 is a cross section schematically illustrating a crystal growth apparatus to grow a crystal from a seed crystal.
FIG. 5 is a schematic view illustrating an example of a group 13 nitride crystal obtainable by the present invention.
FIG. 6 is a schematic view illustrating an example of a group 13 nitride crystal obtainable by the present invention.
FIG. 7-1 is a schematic view illustrating an example of a group 13 nitride crystal obtainable by the present invention.
FIG. 7-2 is a schematic view illustrating a direction to slice a group 13 nitride single crystal.
FIG. 8-1 is a schematic view illustrating an example of a crystal substrate.
FIG. 8-2 is a schematic view illustrating an example of a crystal substrate.
FIG. 8-3 is a schematic view illustrating an example of a crystal substrate.
FIG. 9-1 is a schematic view illustrating a group 13 nitride crystal according to the present embodiment.
FIG. 9-2 is a schematic view illustrating a direction to slice a group 13 nitride single crystal.
FIG. 10-1 is a schematic view illustrating an example of a crystal substrate.
FIG. 10-2 is a schematic view illustrating an example of a crystal substrate.
FIG. 10-3 is a schematic view illustrating an example of a crystal substrate.
FIG. 11-1 is a view illustrating an example of an epitaxially grown crystal.
FIG. 11-2 is a view illustrating a way of slicing a crystal substrate.
FIG. 11-3 is a view illustrating a way of slicing a crystal substrate.
FIG. 12-1 is a view illustrating an example of an epitaxially grown crystal.
FIG. 12-2 is a view illustrating a way of slicing a crystal substrate.
FIG. 12-3 is a view illustrating a way of slicing a crystal substrate.
FIG. 13-1 is a view illustrating an example of an epitaxially grown crystal.
FIG. 13-2 is a view illustrating a way of slicing a crystal substrate.
FIG. 13-3 is a view illustrating a way of slicing a crystal substrate.
FIG. 14-1 is a view illustrating an example of a crystal substrate manufactured by using an epitaxial growth.
FIG. 14-2 is a view illustrating an example of a crystal substrate manufactured by using an epitaxial growth.
FIG. 14-3 is a view illustrating an example of a crystal substrate manufactured by using an epitaxial growth.
FIG. 14-4 is a view illustrating an example of a crystal substrate manufactured by using an epitaxial growth.
FIG. 14-5 is a view illustrating an example of a crystal substrate manufactured by using an epitaxial growth.
FIG. 15 is a schematic view (cross section) illustrating an exemplary configuration of a crystal growth apparatus according to Example 13.
FIG. 16 is a schematic view (cross section) illustrating an exemplary configuration of a crystal growth apparatus according to Example 15.
FIG. 17 is a schematic view illustrating an exemplary configuration of a crystal growth apparatus according to Example 16.
FIG. 18 is a photo image of GaN needle-like crystal manufactured in Example 1.
FIG. 19 is a fluorescent micrograph of GaN needle-like crystal manufactured in Example 2.
FIG. 20 is a photoluminescence spectrum of GaN needle-like crystal manufactured in Example 2.
FIG. 21 is (a) a micrograph of a side surface (m-plane) of GaN crystal manufactured in Example 11, and (b) a fluorescent image of the same position as (a).
FIG. 22 is a fluorescent image of a cross section (c-plane) of GaN crystal manufactured in Example 11.

### Description of Embodiments

A detailed explanation will be made of a gallium nitride crystal, a group 13 nitride crystal, a crystal substrate, and a manufacturing method thereof, with reference to accompanying drawings.

### [1] Crystal Manufacturing Method of Seed Crystal

A manufacturing method according to the present embodiment is a method of manufacturing a needle-like crystal 25 mainly comprised of a group 13 nitride (e.g. gallium nitride), as a group 13 nitride crystal (e.g. a gallium nitride crystal), by a flux method. Incidentally, since the needle-like crystal 25 is used as a seed crystal in a crystal manufacturing method described in the following [3], it may be herein also called the seed crystal 25.

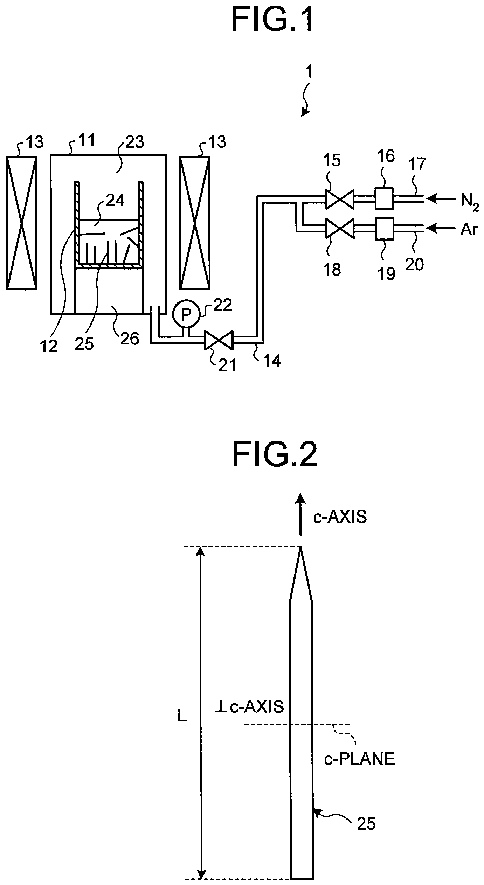

Next, an explanation will be made on a manufacturing method of the needle-like crystal 25 by the flux method. FIG. 1 is a schematic cross section of a crystal growth apparatus 1 to produce the seed crystal 25 according to an embodiment of the present invention. As shown in FIG. 1, the crystal growth apparatus 1 is provided with a pressure resistant vessel 11 made of stainless material and having a closed shape. A reactor vessel 12 is placed on a pedestal 26 in the pressure resistant vessel 11. Incidentally, the reactor vessel 12 is attachable to and detachable from the pedestal 26.

The reactor vessel 12 is a vessel for maintaining a molten mixture 24 of an alkali metal and a material containing at least a group 13 element in order to perform a crystal growth. An operation to put the source material into the reactor vessel 11 is conducted in such a manner that the pressure resistant vessel 11 is put into a glove box under an inert gas atmosphere such as Ar, for example.

The alkali metal used as the source material may be sodium or compound thereof (e.g. sodium azide). Other alkali metals such as lithium, potassium and the like, or compounds of these alkali metals may be used. Plurality kinds of alkali metals may be used.

The material containing at least the group 13 element as the source material may be gallium which is one of group 13 elements. Other group 13 elements such as boron, aluminum, indium and the like, or mixtures thereof may be used.

A gas supplying pipe 14 is connected to the pressure resistant vessel 11 for supplying diluent gas and nitrogen (N₂) gas which is a source material of the group 13 nitride crystal to an inner space 23 of the pressure resistant vessel 11. A gas supplying pipe 14 is branched into a nitrogen supplying pipe 17 and a diluent gas supplying pipe 20. These pipes 17 and 20 can be separated at valves 15 and 18, respectively.

Argon (Ar) gas which is inert gas is preferably used as the diluent gas. However, the embodiment is not limited to this. For example, other inert gas may be used as the diluent gas.

The nitrogen gas is introduced from the nitrogen supplying pipe 17 which is connected to a gas canister or the like containing the nitrogen gas therein. The nitrogen gas from the pipe 17 is subjected to a pressure control by a pressure regulator 16 and then supplied to the gas supplying pipe 14 via the valve 15. On the other hand, the diluent gas (e.g. Ar gas) is introduced from the diluent gas supplying pipe 20 which is connected to a gas canister or the like containing the diluent gas therein. The diluent gas from the pipe 20 is subjected to a pressure control by a pressure regulator 19 and then supplied to the gas supplying pipe 14 via the valve 18. Thus, the pressure regulated nitrogen gas and the pressure regulated diluent gas are supplied to the gas supplying pipe 14 to be mixed there.

The gas mixture of the nitrogen gas and the diluent gas is supplied to the pressure resistant vessel 11 from the gas supplying pipe 14 via the valve 21. The pressure resistant vessel 11 can be removed from the crystal growth apparatus 1 at the valve 21.

A pressure meter 22 is disposed on the gas supplying pipe 14 for monitoring a whole pressure inside of the pressure resistant vessel 11 and controlling pressures inside of the pressure resistant vessel 11.

In the present embodiment, the nitrogen partial pressure can be controlled by controlling the pressures of the nitrogen gas and the diluent gas by means of valves 15 and 18 and the pressure regulators 16 and 19. Since the whole pressure of the pressure resistant vessel 11 can be also controlled, it is possible to reduce evaporation of alkali metal (e.g. sodium) in the reactor vessel 12 by increasing the whole pressure of the pressure resistant vessel 11.

In the crystal manufacturing method according to the present embodiment, the partial pressure of nitrogen in the pressure resistant vessel 11 is preferably 5 MPa to 8 MPa.

As shown in FIG. 1, a heater 13 is disposed around the outer circumference of the pressure resistant vessel 11 for heating the pressure resistant vessel 11 and the reactor vessel 12 and controlling the temperature of the molten mixture 24.

In the crystal manufacturing method according to the present embodiment, the crystal growth temperature of the molten mixture 24 is preferably 860 degrees Celsius to 900 degrees Celsius.

Thus, by heating the pressure resistant vessel 11 and the reactor vessel 12 to the crystal growth temperature, the group 13 element and the alkali metal (impurities may be contained) as the source materials are melted in the reactor vessel 12, and thus the molten mixture 24 is formed. Furthermore, by bringing the nitrogen of the aforementioned partial pressure into contact with the molten mixture 24 and thereby dissolving the nitrogen into the molten mixture 24, the nitrogen as the source material of the group 13 nitride crystal can be supplied to the molten mixture 24 (the molten mixture forming process).

The material for the reactor vessel 12 is not limited to any particular one. Nitrides such as sintered BN, P-BN and the like, oxides such as alumina, YAG and the like, carbides such as SiC and the like, and so on may be used.

An inner wall of the reactor vessel 12, that is, a portion of the reactor vessel 12 which comes into contact with the molten mixture 24 is preferably made of material(s) which allow(s) the crystal growth of the group 13 nitride crystal. As examples of materials allowing the crystal growth of the group 13 nitride crystal, there may be nitrides such as boron nitride (BN), pyrolytic BN (P-BN), aluminum nitride (AlN) and the like, oxides such as alumina, yttrium-aluminum-garnet (YAG) and the like, stainless steel (SUS) and so on. More preferably, the sintered boron nitride (BN) is preferably used for a portion of the rector vessel 12 coming into contact with the aforementioned molten mixture 24.

The sintered BN is obtained by sintering BN powders. The sintered BN has a rough surface with considerable asperity in comparison with the pyrolytic BN (P-BN) manufactured by CVD (Chemical Vapor Deposition). Therefore, nuclei of the group 13 nitride (e.g. gallium nitride) crystal are more likely to be formed on the sintered BN surface rather than the P-BN surface.

Furthermore, the BN is a nitride having a hexagonal crystal structure same as the group 13 nitride crystal (e.g. GaN), nuclei of the group 13 nitride (e.g. gallium nitride) crystal are more likely to be formed on the sintered BN surface rather than a surface of an oxide such as alumina.

Thus, the reactor vessel 12, specifically the portion of the rector vessel 12 coming into contact with the molten mixture 24 is made of the sintered BN. Thereby, more needle-like crystals can be formed in comparison with a case that the reactor vessel made of the P-BN or other oxide is used.

Incidentally, as the material of the portion of the reactor vessel 12 coming into contact with the molten mixture 24, the sintered BN is used in the aforementioned case. However, any other sintered material of any group 13 element other than boron (Al, Ga, etc.) may be used.

In a preferred embodiment, with regard to the source materials in the molten mixture 24 put in the reactor vessel 12, a mol ratio of the alkali metal mol number to the total mol number of the group 13 element (e.g. gallium) and the alkali metal (e.g. sodium) is 75 % to 90 %, the crystal growth temperature of the molten mixture 24 is 860 degrees Celsius to 900 degrees Celsius, and the partial pressure of nitrogen is 5 MPa to 8 MPa.

Incidentally, with regard to the conditions for performing or implementing the manufacturing method when the mol ratio of the group 13 element to the alkali metal is 0.25:0.75 in the molten mixture 24, for example, it is preferable that the crystal growth temperature is 860 degrees Celsius to 870 degrees Celsius, and the partial pressure of nitrogen is 5.5 MPa to 6 MPa (Examples 1, 2). With regard to the conditions for performing or implementing the manufacturing method when the mol ratio of the group 13 element to the alkali metal is 0.2:0.8 in the molten mixture 24, for example, it is preferable that the crystal growth temperature is 860 degrees Celsius to 900 degrees Celsius, and the partial pressure of nitrogen is 6 MPa to 8 MPa (Examples 6, 8).

According to the manufacturing method of the present embodiment, by performing the crystal growth under the aforementioned growth conditions (temperature, partial pressure of nitrogen, mol ratio of alkali metal), it is possible to promote the spontaneous nuclear growth of the group 13 nitride crystal. Therefore, it is possible to remarkably accelerate the crystal growth rate of the group 13 nitride crystal having the hexagonal crystal structure to the - c-axis direction (see FIG. 2). As a result, it is possible to produce the needle-like crystal 25 (the seed crystal 25) of the group 13 nitride (e.g. gallium nitride) elongated in the c-axis direction without strain.

### [2] Seed Crystal

The group 13 nitride crystal described below is the needle-like crystal 25 (the seed crystal 25) manufactured by the manufacturing method mentioned in [1].

FIG. 2 is a schematic view illustrating a c-plane and the c-axis of the needle-like crystal 25 of the group 13 nitride. According to the crystal manufacturing method mentioned in [1], as shown in FIG. 2, it is possible to obtain the needle-like crystal 25 of the group 13 nitride crystal elongated in the c-axis direction by the crystal grow.

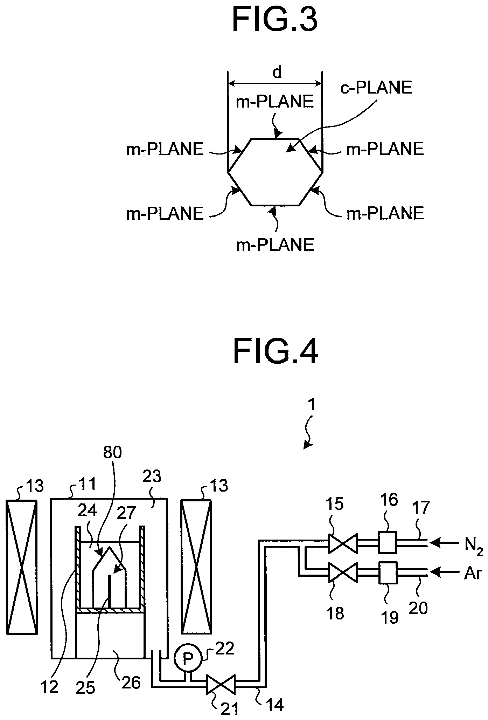

A cross section of the c-plane orthogonal to the c-axis of FIG. 2 is shown in FIG. 3. As shown in FIG. 3, the cross section (c-plane) orthogonal to the c-axis of the needle-like crystal 25 is hexagonal or almost hexagonal. Furthermore, side surfaces of the needle-like crystal 25 corresponding to edges of this hexagon are comprised of m-planes of the hexagonal crystal structure. Incidentally, although it is not shown, side surfaces of the needle-like crystal 25 may include slanted surfaces oblique to the m-planes between m-planes and c-plane.

The maximum diameter of the c-plane of the needle-like crystal 25 is herein referred to as the crystal diameter d. Namely, the crystal diameter d is a length of the longest diagonal line of the hexagon forming the c-plane.

According to the inventors' experience, a practical length of the needle-like crystal to be used as the seed crystal in the flux method is desired to be about 9 mm or more, in view of the seed crystal retaining. Furthermore, if the diameter of the seed crystal is too small, the handling thereof becomes difficult and it may be broken in the course of putting the source materials or in the course of installing the seed crystal. Therefore, it is preferable 100 µm or more.

Thus, the needle-like crystal 25 has characteristics in which the cross section orthogonal to the c-axis has a hexagonal shape or almost hexagonal shape, the length L of the c-axis is 9 mm or more, the crystal diameter d of the cross section orthogonal to the c-axis is 100 µm or more, and the ratio L/d of the length L of the c-axis to the crystal diameter d of the cross section orthogonal to the c-axis is 7 or more (see Examples 1 to 9).

Since the needle-like crystal 25 has the aforementioned size, it can be used as the seed crystal when a bulk crystal of a practical size is manufactured. Conventionally, there has no report that any gallium nitride needle-like crystal having the aforementioned size is manufactured.

According to the manufacturing method mentioned in [1], by controlling the growth conditions (temperature, partial pressure of nitrogen, mol ratio of alkali metal) within the aforementioned suitable range, it is possible to grow the crystal especially in the longitudinal direction with remarkable efficiency. Then, as mentioned before, it is possible to obtain the needle-like crystal 25 of the group 13 nitride more elongated in the longitudinal direction than the prior arts. Also, according to the manufacturing method mentioned in [1], it is possible to obtain the needle-like crystal 25 of the group 13 nitride having 100 µm or more of the crystal diameter d of the cross section orthogonal to the c-axis. Thus, according to the manufacturing method of [1], it is advantageously possible to manufacture the elongated needle-like crystal 25 which can be the seed crystal for the bulk crystal of practical size.

The gallium nitride needle-like crystal 25 has characteristics in which the emission spectrum with electron beam or UV excitation at a room temperature has an emission in a wavelength range of approximately 500 nm to 800 nm, and the emission has a peak intensity in a wavelength range of 600 nm to 650 nm (see <Photoluminescence Measurement Result>).

Namely, according to this, it is possible to emit orange light from the needle-like crystal 25 by irradiating it with an electron beam or ultraviolet beam. Conventionally, there has been no report about any gallium nitride crystal having such an emission spectrum.

Thus, according to the manufacturing method mentioned in [1], it is possible to manufacture the needle-like crystal 25 of gallium nitride emitting orange light by putting sodium and gallium as source materials into the reactor vessel 12 and dissolving the nitrogen gas into the molten mixture 24, without adding impurities for emission center to the source materials.

The needle-like crystal 25 of gallium nitride has
characteristics in which the peak intensity of the emission in the wavelength range of 600 nm to 650 nm is greater than the peak intensity of an emission from the vicinity of the band edge of the gallium nitride(see

### <Photoluminescence Measurement Result>).

The needle-like crystal 25 according to the present embodiment has characteristics in which the dislocation density of the m-plane surface is smaller than 1×10⁶ cm⁻²(see <Dislocation Density Measurement Result>).

Thereby, in a case that the needle-like crystal 25 is used as the seed crystal to form a larger size bulk crystal of the group 13 nitride, it is possible to from the crystal having the small dislocation density.

Impurities may be doped in the gallium nitride crystal according to the present embodiment. For example, a doping impurity such as germanium (Ge), oxygen (O), silicon (Si) and the like, an acceptor impurity such as magnesium (Mg), lithium (Li), strontium (Sr), calcium (Ca), zinc (Zn) and the like, a transition metal for providing magnetic property such as iron (Fe), manganese (Mn), chromium (Cr) and the like, a rare earth element or the like for providing magnetic property or fluorescence such as europium (Eu), erbium (Er), terbium (Tb), thulium (Tm) and the like, congeners such as aluminum (Al), indium (In) and the like may be doped as impurities. Other impurities may de selected and doped depending on the purpose.

### [3] Manufacturing Method of Bulk Crystal from Seed Crystal

The manufacturing method of crystal according to the embodiment includes a crystal growth process to obtain a group 13 nitride crystal with the enlarged c-plane by using the needle-like crystal 25 of the group 13 nitride mentioned in [2] as the seed crystal (the seed crystal 25) and growing the seed crystal 25 toward directions orthogonal to the c-axis by a flux method.

Next, an explanation will be made on a crystal manufacturing method according to a flux method. FIG. 4 is a cross section schematically illustrating a crystal growth apparatus 1 to be used for the crystal growth process to grow the seed crystal 25. The configuration of the crystal growth apparatus 1 is the same of the configuration explained with reference to FIG. 1. Therefore, the same construction carries the same reference numerals and the redundant explanation will be omitted herein.

In the reactor vessel 12, the needle-like crystal 25 (the seed crystal 25) of the group 13 nitride mentioned in [2] is installed. Also in the reactor vessel 12, the alkali metal (e.g. sodium) and the material containing at least the group 13 element (e.g. gallium) are put. The mol ratio between the material containing at least the group 13 element and the alkali metal is not limited to any particular one. However, the mol ratio of the alkali metal to the total mol number of the group 13 element and the alkali metal is preferably 40 to 95 %.

The inner space 23 of the pressure resistant vessel 11 is filled with the nitrogen gas and the diluent gas with predetermined partial gas pressures. The partial pressure of nitrogen gas in the whole gas is not limited to any particular one. However, it is preferably at least 0.1 MPa or more.

The temperature of the molten mixture 24 in the crystal growth process is not limited to any particular one. However, it is preferably at least 700 degrees Celsius.

As exemplary combination of crystal growth process conditions, for example, the temperature is preferably 900 degrees Celsius and the nitrogen partial pressure is 6 MPa, with regard to the molten mixture 24 in which the mol ratio (group 13 nitride: alkali metal) is 0.4:0.6 (see Examples).

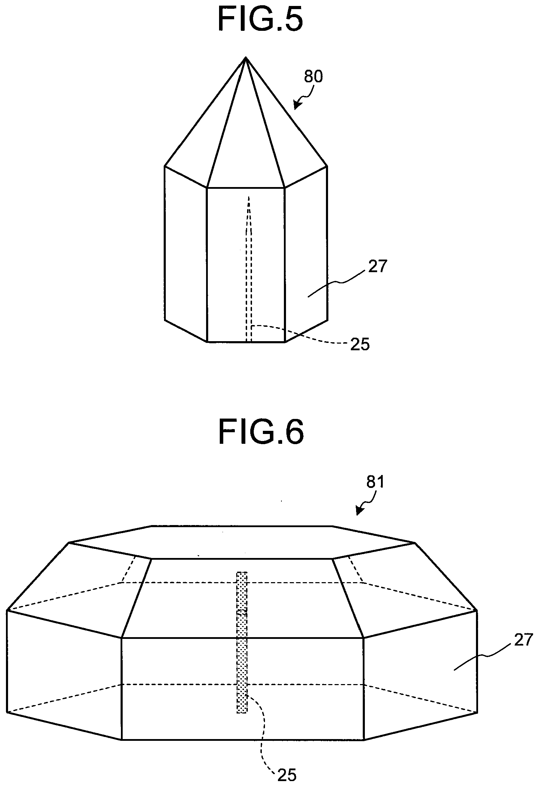

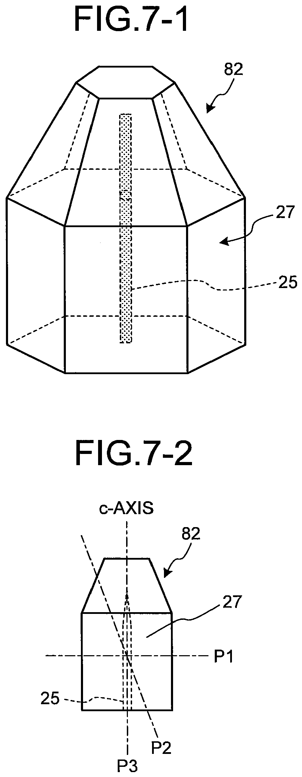

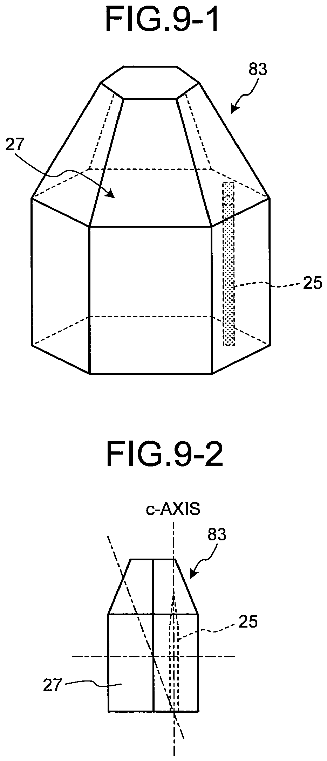

Under these conditions, the seed crystal 25 is grown in radius direction to form the group 13 nitride crystal 27 around the seed crystal 25, as shown in FIG. 4. Namely, in this crystal growth process, the m-planes of the seed crystal become the crystal growth planes to form the group 13 nitride crystal with the group 13 element and the nitrogen supplied from the molten mixture 24. Thus, the group 13 nitride crystals 80 (see FIG. 5), 81 (see FIG. 6), 82 (see FIG. 7-1), and 83 (see FIG. 9-1) in which the c-plane of the seed crystal 25 is enlarged can be obtained.

In such a case that the m-planes of the seed crystal 25 become the crystal growth planes to form the crystal 27 around them, the dislocation density of the crystal 27 is affected by the quality of the m-planes. With regard to this, according to the manufacturing method of the present embodiment, the seed crystal 25 mentioned in [2] is a high quality with low dislocation density. Therefore, in a case that the group 13 nitride crystal 27 is grown from this seed crystal 25, it is possible to reduce the dislocation propagated from the seed crystal 25 to the crystal 27. Thereby, the dislocation density of the group 13 nitride crystal 27 can be suppressed to a small extent, and larger sized and high quality group 13 nitride crystals 80 to 83 can be manufactured.

In the crystal manufacturing method of the present embodiment, the seed crystal 25 and the group 13 nitride crystal 27 grown from the seed crystal 25 may be of the same material (e.g. gallium nitride). Therefore, different from a case that a hetero material such as aluminum nitride (AlN) is used as the seed crystal, the lattice constant and the thermal expansion coefficient can be matched and thereby the occurrence of the dislocation due to the difference in the lattice constant or thermal expansion coefficient can be eliminated.

Furthermore, the seed crystal 25 and the group 13 nitride crystal 27 are manufactured by the same crystal manufacturing method (the flux method). Therefore, in comparison with a case that the seed crystal 25 and the group 13 nitride crystal 27 are manufactured by different manufacturing methods, the matching of the lattice constant and the thermal expansion coefficient can be improved, and thereby the occurrence of the dislocation can be further suppressed.

As mentioned above, according to the crystal manufacturing method of the present embodiment, it is possible to manufacture the group 13 nitride crystal with practical size. Also, in comparison with a case where the hetero material is used as the seed crystal, it is possible to manufacture the group 13 nitride crystal with high quality and low dislocation density.

Hereinabove, the flux method has been explained for the crystal manufacturing method. However, the crystal manufacturing method is not limited to any particular one. A vapor phase growth method such as HVPE, or any liquid phase growth method other than flux method may be used for the crystal growth.

### [4] Group 13 Nitride Crystal (Bulk Crystal)

The group 13 nitride crystal described below is a group 13 nitride crystal manufactured by the manufacturing method mentioned in [3].

FIG. 5, FIG. 6, FIG. 7-1 and FIG. 9-1 show each example of group 13 nitride crystals 80, 81, 82, and 83 according to the present embodiment. As shown in these figures, the seed crystal 25 is contained inside of the group 13 nitride crystals 80 to 83, in the group 13 nitride crystals 80 (see FIG. 5), 81 (see FIG. 6), 82 (see FIG. 7-1) and 83 (see FIG. 9-1).

The group 13 nitride crystals 80 to 83 have characteristics in which each of them contains at least a part of the needle-like crystal 25 of the group 13 nitride used as the seed crystal.

Incidentally, it is enough that the position of the seed crystal 25 in the group 13 nitride crystals 80 to 83 is located inside of the group 13 nitride crystals 80 to 83. It may be contained near the central portion (near the center of the hexagon of the cross section) of the group 13 nitride crystals 80 to 83 as shown in FIG. 5, FIG. 6 and FIG. 7-1. Or, it may be contained near the periphery (region closer to edges of the hexagon than the center) of the group 13 nitride crystals 80 to 83 as shown in FIG. 9-1.

These crystals can be obtained by growing the seed crystal 25 according to the crystal manufacturing method mentioned in [3]. Namely, the group 13 nitride crystals 80 to 83 can be manufactured by evenly growing the gallium nitride crystal 27 around the seed crystal 25 as the center, or by growing the crystal toward a specific direction from the seed crystal 25.

Thus, the group 13 nitride crystals 80 to 83 contain at least a part of the seed crystal 25. Since the seed crystal 25 emits an orange light, the position of the seed crystal 25 can be visually confirmed. Furthermore, when the group 13 nitride crystals 80 to 83 are processed, the general direction of the crystal orientation can be assumed by the seed crystal 25. Thereby, it is possible to assume roughly the direction to cut or slice the crystals 80 to 83.

Incidentally, in an example of FIG. 5 for example, there is depicted the group 13 nitride crystal 80 having a shape in which the m-planes and the c-plane (see FIG. 2) are formed, and a six-sided pyramid is placed upon a hexagonal column-like crystal having an top face which becomes a bottom face of the six-sided pyramid. However, the shape of the group 13 nitride crystal is not limited to any particular one. It may be a six-sided pyramid-like shape without m-planes. Furthermore, impurities may be doped in the group 13 nitride crystal 27.

According to the crystal manufacturing method of the present embodiment, the seed crystal 25 having the length L of 9 mm or more as mentioned in [2] is used. Therefore, it is possible to obtain the group 13 nitride crystals 80 to 83 having the length L of 9 mm or more, and the cross section area larger than the seed crystal 25.

### [5] Manufacturing Method of Crystal Substrate

The manufacturing method of the crystal substrate according to the present embodiment is a method of manufacturing a plurality of crystal substrates from the group 13 nitride crystals 80 to 83 mentioned in [4].

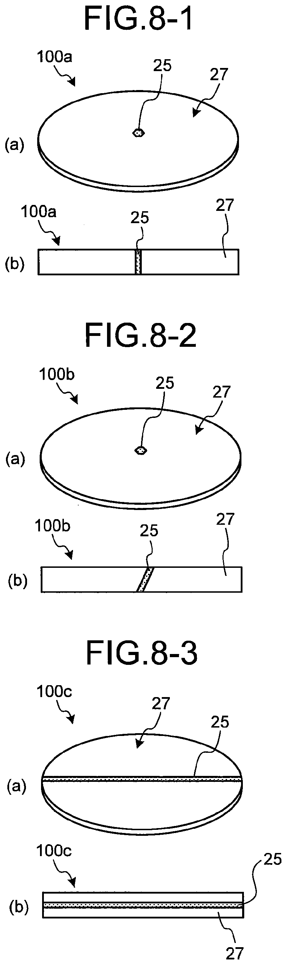

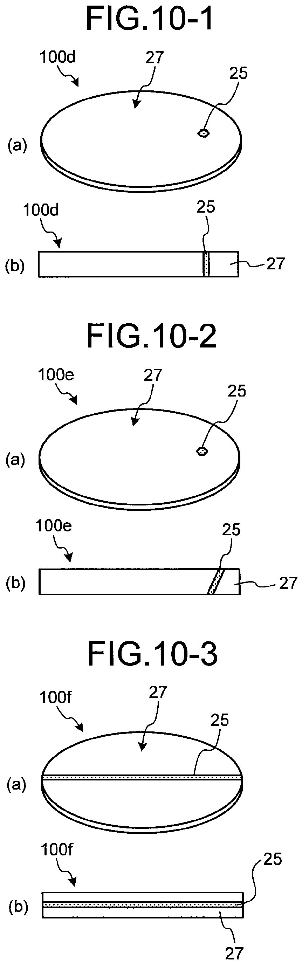

Hereinafter, an example of the manufacturing method according to the present embodiment will be explained with reference to drawings. FIG. 7-2 and FIG. 9-2 are schematic views showing directions for slicing the group 13 nitride crystal 82 (FIG. 7-1) and the group 13 nitride crystal 83 (FIG. 9-1), respectively. FIGs. 8-1 to 8-3, and FIGs. 10-1 to 10-3 are schematic views showing examples of crystal substrate 100 (100a to 100f) obtained through slicing.

The manufacturing method according to the embodiment characteristically includes a process of cutting out the crystal substrate so as to include at least a part of the seed crystal 25 when the group 13 nitride crystals 80 to 83 are sliced.

In this case, the crystal substrate 100a as shown in FIG. 8-1 may be obtained by slicing the crystal orthogonally to the c-axis of the seed crystal 25 as shown by a dotted-dashed line P1 in FIG. 7-2. Alternatively, the crystal substrate 100b as shown in FIG. 8-2 may be obtained by slicing the crystal obliquely to the c-axis of the seed crystal 25 as shown by a dotted-dashed line P2 in FIG. 7-2. Alternatively, the crystal substrate 100c as shown in FIG. 8-3 may be obtained by slicing the crystal orthogonal to (*sic*) the c-axis of the seed crystal 25 as shown by a dotted-dashed line P3 in FIG. 7-2.

The crystal substrate 100 (100a to 100f) is subjected to various treatments such as shaping process, surface treatment and the like after slicing for obtaining the crystal substrate 100 (100a to 100f) as shown in FIGs. 8-1 to 8-3 and FIGs. 10-1 to 10-3.

According to the manufacturing method of the present embodiment, the crystal substrate 100 is cut out from the group 13 nitride crystals 82 and 83 in which the length in the c-axis direction is 9 mm or more, and the crystal diameter d is 100 µm or more. Therefore, whether cut along the c-plane or along a plane other than the c-plane, it is possible to obtain the large area of the substrate main face, and manufacture the crystal substrate 100 with practical size applicable to various semiconductor devices.

Furthermore, cutting is possible in any direction. Therefore, it is possible to manufacture the large sized crystal substrate 100 having a main face comprised of any crystal plane such as {0001} plane (c-plane), {10-10} plane (m-plane), {11-20} plane (a-plane), {10-11} plane, {20-21} plane, {11-22} plane and so on.

### [6] Crystal Substrate

The crystal substrate described below is a crystal substrate 100 manufactured by the manufacturing method mentioned in [5]. Namely, the crystal substrate 100 characteristically includes at least a part of the seed crystal 25 mentioned in [2].

As shown in FIGs. 8-1 to 8-3 and FIGs. 10-1 to 10-3, the seed crystal 25 used in the crystal manufacturing process is contained in the crystal substrate 100 (100a to 100f). At least a part of the outer surface of the seed crystal 25 is surrounded by the group 13 nitride crystal 27 grown from the seed crystal 25. Incidentally, the group 13 nitride crystal 27 may surround an entire surface of the seed crystal 25 or may surround at least a part of the surface.

Insofar as the seed crystal 25 is contained inside of the group 13 nitride crystal 27, the position thereof is not limited to any particular one. For example, as shown in FIG. 8-1 and FIG. 8-2, the seed crystal 25 may be disposed near the center part of the main face of the crystal substrate 100. In this case, the c-axis of the seed crystal 25 may be disposed perpendicular to the main face as shown in FIG. 8-1, or may be disposed oblique to the main face as shown in FIG. 8-2.

As shown in FIG. 8-3 and FIG. 10-3, the seed crystal 25 may be disposed so that the c-axis of the seed crystal 25 is parallel to the main face of the substrate. Furthermore, the seed crystal 25 may be disposed at a position other than the center area of the main face of the substrate 100. For example, as shown in FIG. 10-1 and FIG. 10-2, the seed crystal 25 may be disposed near the periphery of the main face of the substrate 100.

The seed crystal 25 emits an orange light as mentioned in [2]. Thereby, the position of the seed crystal 25 in the crystal substrate 100 can be readily confirmed. Therefore, for example, in a case that the electrical property of the seed crystal 25 is different from that of the crystal 27 grown around the seed crystal, it is possible to improve the quality of device by fabricating the device with avoiding the seed crystal 25.

### [7] Crystal Manufacturing Method based on Epitaxial Growth

The crystal manufacturing method according to the present embodiment characteristically includes a process to epitaxially grow a group 13 nitride crystal upon at least one main face of the crystal substrate 100 mentioned in [6].

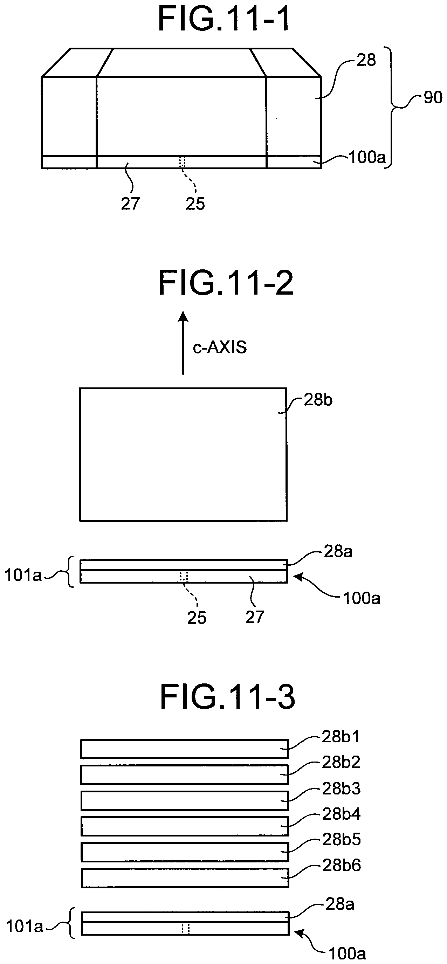

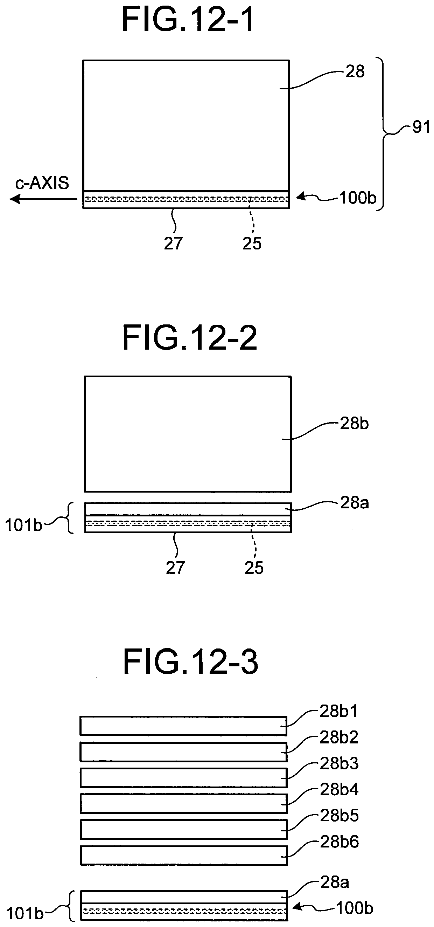

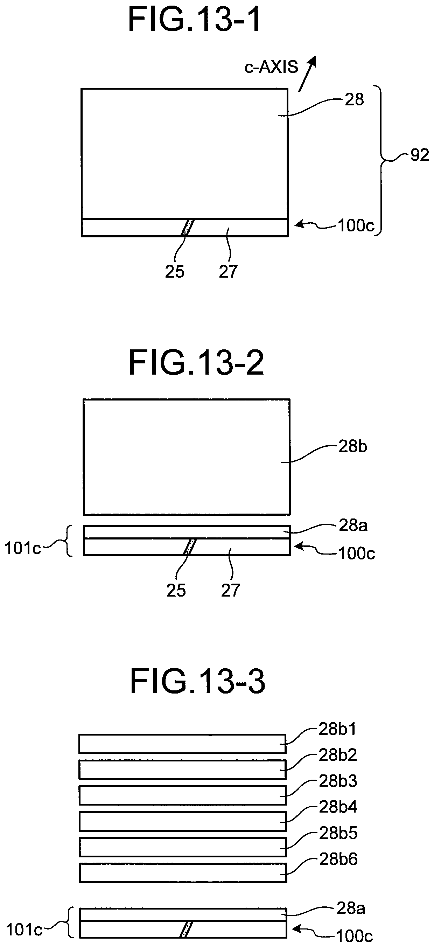

FIG. 11-1, FIG. 12-1 and FIG. 13-1 illustrate an example of crystal 90 obtained by the epitaxial growth. As shown in FIG. 11-1, FIG. 12-1 and FIG. 13-1, respectively, the group 13 nitride crystal 28 is grown (epitaxially grown) on the main face of the crystal substrate 100 (100a, 100b, 100c). Thus, the group 13 nitride crystal 90, 91 or 92 is produced in which the crystal 28 is stacked on the crystal substrate 100.

Incidentally, the crystal growth method of the crystal 28 is not limited to any particular one. A vapor phase growth method such as HVPE (see Example 15), or a liquid phase growth method like as the flux method (see Example 16) may be used. In the epitaxial growth process, impurities may be doped in the crystal 28.

Thus, according to the manufacturing method of the present invention, an entire surface (entire area) of the main face of the group 13 nitride crystal substrate 100 (100a, 100b, 100c) can be used to grow the crystal. The group 13 nitride crystal 28 having its main face of the generally same area as that of the substrate main face can be grown on the crystal substrate 100.

Also according to the present embodiment, the crystal having the same quality as the crystal substrate 100 can be grown, since it is epitaxially grown on the high quality crystal substrate 100. Namely, the crystal orientation or the dislocation density can be of the same extent between the crystal 28 and the crystal substrate 100.

### [8] Crystal manufactured by Epitaxial Growth

The group 13 nitride crystal described below is the group 13 nitride crystal 90, 91, or 92 manufactured by the manufacturing method mentioned in [6].

As shown in FIG. 11-1, FIG. 12-1, and FIG. 13-1, in the group 13 nitride crystal 90, 91, or 92, the group 13 nitride crystal 28 is epitaxially grown on at least one substrate main face of the crystal substrate 100a, 100b, or 100c.

Incidentally, in the group 13 nitride crystal depicted in FIG. 11-1, FIG. 12-1, and FIG. 13-1, the group 13 nitride crystal 28 is epitaxially grown on the crystal substrate 100 (100a, 100b, 100c) illustrated in FIG. 8. However, the group 13 nitride crystal 28 may be epitaxially grown on the crystal substrate 100 (100d, 100e, 100f) illustrated in FIG. 10.

### [9] Manufacturing Method of Crystal Substrate by Cutting Epitaxially Grown Crystal

The manufacturing method of the crystal substrate according to the present embodiment characteristically includes a process to produce the group 13 nitride crystal substrate by processing the crystal cut out from the group 13 nitride crystal 90, 91, or 92 mentioned in [8].

FIG. 11-2, FIG. 12-2, and FIG. 13-2, as well as FIG. 11-3, FIG. 12-3, and FIG. 13-3, are view illustrating a way of slicing the crystal substrate according to the present embodiment. Firstly, as shown in FIG. 11-2, FIG. 12-2, and FIG. 13-2, the group 13 nitride crystal 90 is cut into a crystal substrate 101 including the crystal substrate 100 and a crystal 28b including no crystal substrate 100. Then, as shown in FIG. 11-3, FIG. 12-3, and FIG. 13-3, the crystal 28b is sliced into a plurality of crystal substrates 28b1 to 28b6. Then, each of the crystal substrates 101, 28b1 to 28b6 is subjected to shaping, grinding, polishing and surface treatment and the like.

Namely, the manufacturing method of the present embodiment includes a process to cut out the group 13 nitride crystal 90, 91, or 92 without including the seed crystal 25. Thereby, it is possible to produce a plurality of even or uniform crystal substrates 28b1 to 28b6.

Incidentally, the thickness of the crystal 28 formed on the crystal substrate 100 is not limited to any particular one. For example, the crystal substrate 101 may be produced by growing the crystal 28a by a thickness required for obtaining a target thickness of the crystal substrate 101, without growing the crystal 28b portion which is to be cut off in FIG. 11-1.

In FIG. 11-3, FIG. 12-3, and FIG. 13-3, the crystal 28b is sliced parallel to the substrate main face. However, the direction to slice the crystal 28b is not limited to this. The crystal 28b may be sliced in any direction.

According to the manufacturing method of the present embodiment, it is possible to produce a plurality of group 13 nitride crystal substrates (28b1 to 28b6) having a main face comprised of {0001} plane (c-plane), {10-10} plane (m-plane), {11-20} plane (a-plane), {10-11} plane, {20-21} plane, {11-22} plane or the like.

Furthermore, the crystal substrates (28b1 to 28b6) of various crystal faces produced by the manufacturing method of the present embodiment can be used as new seed crystals to produce crystal substrates of various crystal faces by the manufacturing method of the aforementioned [7] and [9].

Furthermore, according to the manufacturing method of the present embodiment, each of the crystal substrates (28b1 to 28b6) is cut from the crystal 28 having the low dislocation density as mentioned above. Therefore, it is possible to produce the crystal substrates (28b1 to 28b6) of high quality with low dislocation density.

### [10] Crystal Substrate manufactured from Epitaxially Grown Crystal

The crystal substrate described below is a crystal substrate 101 produced by the manufacturing method mentioned in [8]. Namely, the crystal substrate 101 is a substrate in which the crystal 28 is epitaxially grown on the crystal substrate 100 (100a to 100f).

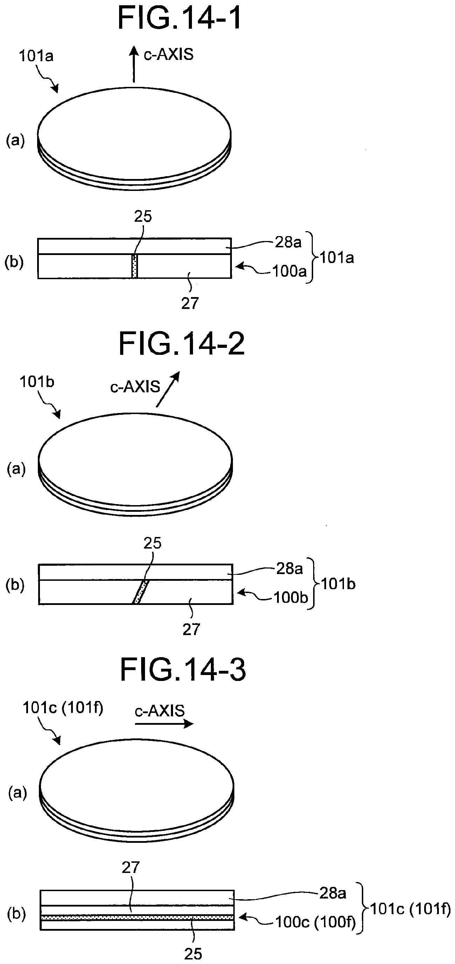

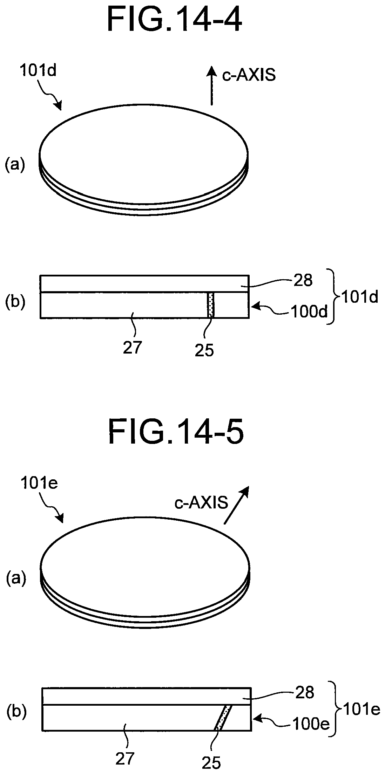

FIG. 14-1 to FIG. 14-5 show examples of the crystal substrate 101 produced by the epitaxial growth. Namely, FIG. 14-1 shows the crystal substrate 101a produced by epitaxially growing the crystal 28 on the crystal substrate 100a. FIG. 14-2 shows the crystal substrate 101b produced by epitaxially growing the crystal 28 on the crystal substrate 100b. FIG. 14-3 shows the crystal substrate 101c (101f) produced by epitaxially growing the crystal 28 on the crystal substrate 100c (100f). FIG. 14-4 shows the crystal substrate 101d produced by epitaxially growing the crystal 28 on the crystal substrate 100d. FIG. 14-5 shows the crystal substrate 101e produced by epitaxially growing the crystal 28 on the crystal substrate 100e.

As shown in each figure, the crystal 28 portion does not include the seed crystal 25. Therefore, the seed crystal 25 is not exposed on the surface at the crystal 28 side (the surface of the substrate main face) in the crystal substrate 101 (101a to 101 f). Therefore, when the surface at the crystal 28 side is used for producing devices, the crystal 28 whose crystallinity and property is even can be used, and thereby the device performance can be improved.

Furthermore, the seed crystal 25 emits an orange light as mentioned in [2], and the crystal 27 grown from the seed crystal 25 and the epitaxially grown crystal 28 are colorless and transparent. Therefore, the position of the seed crystal 25 can be visually confirmed.

Thus even if the seed crystal 25 is not exposed on the surface, the position or orientation of the seed crystal 25 can be visually confirmed. Therefore, it is possible to realize both the improvement of the device performance and the efficiency of the device production.

### Examples

Hereinafter, Examples are described for further understanding the present invention in detail. However, the present invention is not limited to these Examples. Reference numerals correspond to the configuration of the crystal growth apparatus explained with reference to FIG. 1 and FIG. 4.

### (Example 1)<Manufacturing Example 1 of Seed Crystal>

Gallium and sodium were input with a mol ratio as 0.25:0.75 into the reactor vessel 12 made of a sintered BN and having the inner diameter of 55 mm.

In a glove box, the reactor vessel 12 was placed into the pressure resistant vessel 11 under a high purity Ar gas atmosphere. The valve 21 was closed to shut out the inner space of the reactor vessel 12 from the outer atmosphere, so that the pressure resistant vessel 11 was sealed under the state filled with Ar gas.

Then, the pressure resistant vessel 11 was taken out from the glove box and assembled into the crystal growth apparatus 1. Specifically, the pressure resistant vessel 11 was installed at a predetermined position with respect to the heater 13 and connected to the gas supplying pipe 14 of nitrogen gas and argon gas at the valve 21 portion.

Next, the valve 21 and the valve 18 were opened to introduce Ar gas from the diluent gas supplying pipe 20. The pressure of Ar gas was controlled by the pressure regulator 19, so that the whole pressure in the pressure resistant vessel 11 became 1 MPa. Then, the valve 18 was closed.

Then, the nitrogen gas was introduced from the nitrogen gas supplying pipe 17. The pressure of the nitrogen gas was controlled by the pressure regulator 16 and then the valve 15 was opened, so that the whole pressure in the pressure resistant vessel 11 became 3.2 MPa. Namely, the partial pressure of the nitrogen in the inner space 23 of the pressure resistant vessel 11 was 2.2 MPa. The ratio of argon partial pressure : nitrogen partial pressure was 1 : 2.2. The ratio of nitrogen partial pressure : whole pressure was 2.2 : 3.2. Then, the valve 15 was closed and the pressure regulator 16 was set at 8 MPa.

Next, the heater 13 was turned on to heat the reactor vessel 12 to a crystal growth temperature. In Example 1, the crystal growth temperature was 860 degrees Celsius.

At the crystal growth temperature, the gallium and the sodium in the reactor vessel 12 were melted to form a molten mixture 24. The temperature of the molten mixture 24 became the same temperature as that of the reactor vessel 12. Until heated to this temperature, in the crystal growth apparatus 1 of this Example, gas in the pressure resistant vessel 11 was heated so that the whole pressure became 8 MPa. Namely, since the ratio of the nitrogen partial pressure : the whole pressure is 2.2 : 3.2, the nitrogen pressure in this case was 5.5 MPa.

Next, the valve 15 was opened, so that the nitrogen gas pressure became 8 MPa and the pressure equilibrium state was established between the inside of the pressure resistant vessel 11 and the inside of the nitrogen supplying pipe 17. Thereby, when the nitrogen in the pressure resistant vessel 11 was consumed for the crystal growth of the gallium nitride, the consumed amount of the nitrogen gas can be supplied to the pressure resistant vessel 11, and thereby the nitrogen partial pressure in the pressure resistant vessel 11 can be maintained at 5.5 MPa.

The reactor vessel 12 was maintained at this state for 250 hours to form gallium nitride crystals. Then, the heater 13 was controlled to cool the pressure resistant vessel 11 to a room temperature (approximately 20 degrees Celsius).

After decreasing the gas pressure in the pressure resistant vessel 11, the pressure resistant vessel 11 was opened. In the reactor vessel 12, many needle-like crystals 25 of GaN were formed. The needle-like crystals 25 of gallium nitride were grown toward -c-axis ([000-1]) direction.

Grown needle-like crystals of GaN were colorless and transparent, had the crystal diameter d of about 200 to 500 µm, had the length L of about 10 to 18 mm, and had the ratio L/d of the length L to the crystal diameter d was about 20 to 90. The needle-like crystals 25 of GaN were grown generally parallel to the c-axis, and had the m-planes (see FIG. 3) formed on the side surfaces of each crystal.

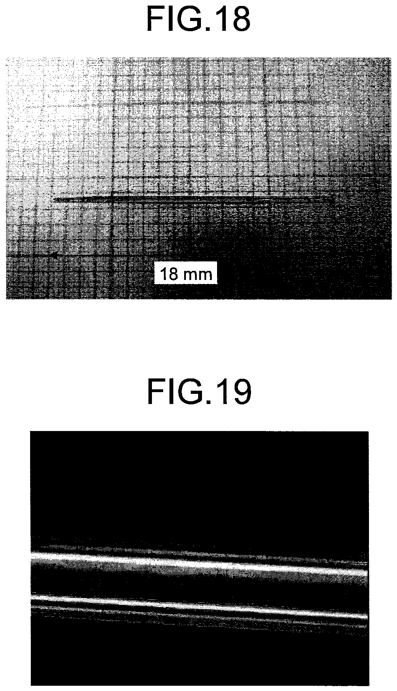

FIG. 18 is a photo image of the needle-like crystal 25 of GaN manufactured by Example 1. The length was 18 mm. The needle-like crystal 25 of GaN started the growth from the BN surface of the reactor vessel 12, and grew toward the growth direction which is nitrogen polarity surface side (- c-axis direction) of the c-plane of the needle-like crystal GaN. Time average growth rate in the length direction was assumed 40 to 72 µm/h, which was remarkably faster than the growth rate in the width direction.

The needle-like crystal 25 of GaN was etched by an acidic solution to observe the c-plane and the m-plane. No or few etch pit was observed on both surfaces. The etch pit is considered to correspond to the dislocation. Therefore, it was confirmed that the needle-like crystal 25 of GaN is high quality with less dislocation.

### (Example 2) <Manufacturing Example 2 of Seed Crystal>

The crystal growth was conducted similarly to Example 1 except that the crystal growth temperature was 870 degrees Celsius, and the partial pressure of nitrogen was 6 MPa. The mol ratio of gallium to sodium was 0.25: 0.75. As a result, a lot of needle-like crystals of GaN having a length of 10 mm to 14 mm were obtained.

One needle-like crystal 25 having a length of about 20 mm, and one needle-like crystal 25 having a length of about 21 mm with a microcrystal attached around the tip were also obtained. The diameters of these needle-like crystals 25 were 150 to 500 µm. The each cross section shape orthogonal to the c-axis of the crystal was a hexagonal shape.

Incidentally, the needle-like crystal of GaN started the growth from the BN surface of the reactor vessel 12, similarly to Example 1, and grew toward the growth direction which is the nitrogen polarity surface side of the c-plane of the needle-like crystal 25 of GaN, that is grew toward the -c-axis ([000-1]) direction. The time average growth rate in the length direction was assumed 40 to 84 µm/h, and was remarkably faster than the growth rate in the width direction.

### (Example 3) <Manufacturing Example 3 of Seed Crystal>

The crystal growth was conducted similarly to Example 1 except that the crystal growth temperature was 870 degrees Celsius, the partial pressure of nitrogen was 6 MPa, and the mol ratio of gallium to sodium was 0.2: 0.8. As a result, needle-like crystals of GaN having a length up to about 10 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 4) <Manufacturing Example 4 of Seed Crystal>

The crystal growth was conducted similarly to Example 1 except that the partial pressure of nitrogen was 6 MPa. The crystal growth temperature was 860 degrees Celsius, and the mol ratio of gallium to sodium was 0.25: 0.75. As a result, needle-like crystals of GaN having a length up to about 10 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 5) <Manufacturing Example 5 of Seed Crystal>

The crystal growth was conducted similarly to Example 1 except that the partial pressure of nitrogen was 5 MPa. The crystal growth temperature was 860 degrees Celsius, and the mol ratio of gallium to sodium was 0.25: 0.75. As a result, needle-like crystals of GaN having a length up to about 10 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 6) <Manufacturing Example 6 of Seed Crystal>

The crystal growth was conducted similarly to Example 1 except that the crystal growth temperature was 900 degrees Celsius, the partial pressure of nitrogen was 6 MPa, and the mol ratio of gallium to sodium was 0.2: 0.8. As a result, needle-like crystals of GaN having a length up to about 15 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 7) <Manufacturing Example 7 of Seed Crystal>

The crystal growth was conducted similarly to Example 1 except that the crystal growth temperature was 900 degrees Celsius, the partial pressure of nitrogen was 8 MPa, and the mol ratio of gallium to sodium was 0.1: 0.9. As a result, needle-like crystals of GaN having a length up to about 9 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 8) <Manufacturing Example 8 of Seed Crystal>

The crystal growth was conducted similarly to Example 1 except that the crystal growth temperature was 890 degrees Celsius, the partial pressure of nitrogen was 8 MPa, and the mol ratio of gallium to sodium was 0.2: 0.8. As a result, needle-like crystals of GaN having a length of about 10 to 13 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Example 9) <Manufacturing Example 9 of Seed Crystal>

The crystal growth was conducted similarly to Example 1 except that the crystal growth temperature was 900 degrees Celsius, the partial pressure of nitrogen was 8 MPa, and the mol ratio of gallium to sodium was 0.2: 0.8. As a result, needle-like crystals of GaN having a length of about 10 mm were obtained.

The diameters d of the obtained needle-like crystals 25 were 100 to 400 µm. The each cross section shape orthogonal to the c-axis of the crystal was a hexagonal shape. Incidentally, the needle-like crystals 25 of GaN grew toward the -c-axis ([000-1]) direction.

### (Comparative Example 1)

The crystal growth was conducted similarly to Example 1 except that the crystal growth temperature was 910 degrees Celsius, the partial pressure of nitrogen was 8 MPa, and the mol ratio of gallium to sodium was 0.2: 0.8. As a result, although a few microcrystals of GaN having a length of about 100 µm were obtained, any needle-like crystal of GaN having a length of 9 mm or more was not obtained.

### (Comparative Example 2)

The crystal growth was conducted similarly to Example 1 except that the crystal growth temperature was 890 degrees Celsius, the partial pressure of nitrogen was 8 MPa, and the mol ratio of gallium to sodium was 0.05: 0.95. As a result, although a lot of microcrystals of GaN having a length of about 100 µm were formed on the inner wall of the crucible, any needle-like crystal of GaN having a length of 9 mm or more was not obtained.

### (Comparative Example 3)

The crystal growth was conducted similarly to Example 1 except that the crystal growth temperature was 850 degrees Celsius, the partial pressure of nitrogen was 8 MPa, and the mol ratio of gallium to sodium was 0.2: 0.8. As a result, a lot of plane-like crystals of GaN having about a few hundreds µm length of a diagonal line of a hexagon and a few plate-like crystals of GaN having about 1 mm length of a diagonal line of a hexagon were obtained. However, any needle-like crystal of GaN having a length of 9 mm or more was not obtained.

### (Comparative Example 4)

The crystal growth was conducted similarly to Example 1 except that the crystal growth temperature was 870 degrees Celsius, the partial pressure of nitrogen was 9 MPa, and the mol ratio of gallium to sodium was 0.2: 0.8. As a result, a few column-like crystals of GaN having a length of about 1 mm and a lot of plane-like microcrystals of GaN having about a few hundreds µm length of a diagonal line of a hexagon were obtained. However, any needle-like crystal of GaN having a length of 9 mm or more was not obtained.

As apparent from the aforementioned Examples 1 to 9 and Comparative Examples 1 to 4, it is preferable that conditions for conducting the manufacturing method of the needle-like crystal (seed crystal) 25 are arranged so that the mol ratio of sodium to the total mol number of gallium and sodium is within a range of 75 % to 90 %, the crystal growth temperature of the molten mixture is within a range of 860 degrees Celsius to 900 degrees Celsius, and the partial pressure of nitrogen is within a range of 5 MPa to 8 MPa.

Also, as apparent from Examples 1 and 2, it is preferable that conditions for conducting the manufacturing method of the needle-like crystal (seed crystal) 25 are arranged so that the crystal growth temperature is within a range of 860 degrees Celsius to 870 degrees Celsius, and the partial pressure of nitrogen is within a range of 5.5 MPa to 6 MPa, for the molten mixture 24 in which the mol ratio of group 13 element to alkali metal is 0.25 : 0.75.

Furthermore, as apparent from Examples 6 and 8, it is preferable that conditions for conducting the manufacturing method of the needle-like crystal (seed crystal) 25 are arranged so that the crystal growth temperature is within a range of 890 degrees Celsius to 900 degrees Celsius, and the partial pressure of nitrogen is within a range of 6 MPa to 8 MPa, for the molten mixture 24 in which the mol ratio of group 13 element to alkali metal is 0.2 : 0.8.

By setting such preferable conditions, as apparent from Examples 1 to 9, a longer needle-like crystal of group 13 nitride can be obtained for example in which a length L of the crystal is 10 mm or more, and the ratio L/d of length L to crystal diameter d is about 7 or more, or 15 or more.

Next, the results of various measurements conducted for the needle-like crystals 25 of GaN manufactured by Examples 1 to 9 will be shown below.

### <Measurement Result of Dislocation Density>

The m-plane surfaces of needle-like crystals 25 of GaN manufactured by Examples 1 to 9 were etched by acid (mixed acid of phosphorus acid and sulfuric acid, 230 degrees Celsius) to form etch pits for calculating the etch pit density. The etch pit density was in the order of 10¹ to 10⁴ cm⁻². The etch pit is considered to correspond to the dislocation. Therefore, it is confirmed that the dislocation density of the needle-like crystal 25 of GaN was 10¹ to 10⁴ cm⁻² or less.

Thus, according to this measurement result, it is apparent that the needle-like crystal 25 of GaN manufactured by the manufacturing method mentioned in [1] has a dislocation density of m-plane surfaces less than 1×10⁶ cm⁻².

### <Measurement Result of Impurity Density>

The impurity densities of the needle-like crystals 25 of GaN manufactured by Examples 1 to 9 were measured by means of a SIMS (Secondary Ion Mass Spectroscopy). As a result, the oxygen level was 5×10¹⁷ cm⁻³ which was a background level of the analyzer. Incidentally, with the analyzer whose oxygen background level reduced to 2×10¹⁷ cm⁻³, the detected oxygen level was also reduced to the background level (2×10¹⁷ cm⁻³). Therefore, the oxygen level in the actual crystal can be estimated to be further lower than the background level.

Furthermore, the carbon level, the hydrogen level and the sodium level were also the background level of the detection by the SIMS (carbon: 3×10¹⁵ cm⁻³, hydrogen: 3×10¹⁶ cm⁻³, sodium: 4×10¹³ cm⁻³). Furthermore, although there are variations among crystals, boron (B) was detected in a range of about 2×10¹⁸ to 2×10¹⁹ cm⁻².

Therefore, it was confirmed that the impurities (oxygen, carbon, hydrogen, sodium) were suppressed to low levels in the needle-like crystals 25 of GaN manufactured by Examples 1 to 9, and the needle-like crystals 25 of GaN manufactured by Examples 1 to 9 were high quality GaN crystal.

### <Observation Result by Fluorescent Microscope>

The needle-like crystals 25 of GaN manufactured by Examples 1 to 9 were observed by means of a fluorescent microscope. The light source of the fluorescent microscope had a wavelength of 320 to 400 nm, and a peak wavelength of 370 nm. A fluorescent image having a wavelength of 420 nm or more (□420 nm) was observed through a filter. The crystal was observed as an orange fluorescent image.

FIG. 19 is a fluorescent microscope image of a m-plane of the needle-like crystal 25 of GaN manufactured by Example 2. As shown in FIG. 19, an orange fluorescent image was observed.

### <Measurement Result of Photoluminescence>

Photoluminescence (PL) of the needle-like crystals 25 of GaN manufactured by Examples 1 to 9 was measured at a room temperature. He-Cd laser having a wavelength of 325 nm was used as an excitation light source.

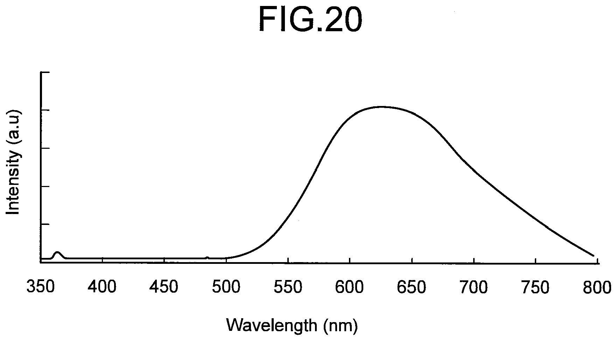

FIG. 20 is a photoluminescence spectrum at a room temperature of the needle-like crystal 25 of GaN manufactured by this Example 2. As shown in FIG. 20, in the photoluminescence spectrum, an emission from a vicinity of the band edge (around 364 nm) of gallium nitride and a broad emission having a peak intensity around 625 nm in a range of 500 nm to 800 nm were observed. The peak intensity of the broad emission in the range of 500 nm to 800 nm was stronger than the peak intensity of the emission from the vicinity of the band edge.

As shown in FIG. 20, also in each photoluminescence spectrum of the needle-like crystals 25 of GaN manufactured by Examples 1 to 9, an emission from a vicinity of the band edge (around 364 nm) of gallium nitride and a broad emission in a range of 500 nm to 800 nm were observed. The peak intensity of the broad emission in the range of 500 nm to 800 nm was stronger than the peak intensity of the emission from the vicinity of the band edge (around 364 nm).

Incidentally, the peak intensities of the broad emission in the range of 500 nm to 800 nm vary with crystals. For example, the peak intensity was 625 nm, or 640 nm. Generally, the peak intensity is in a range of 600 nm to 650 nm.

Conventionally, in a photoluminescence emission spectrum obtained by irradiating GaN crystals with electron beam or UV (Ultraviolet) beam for excitation and emission, there has been reported en emission called Yellow Band having a peak around 550 nm as an emission of longer wavelength than the emission from the vicinity of the band edge (around 364 nm).

However, in the needle-like crystals 25 of GaN manufactured by Examples 1 to 9, an emission which is other than Yellow Band and has a peak intensity around 600 nm to 650 nm in longer wavelength side of Yellow Band was observed. This emission around 600 nm to 650 nm is an emission in a wavelength range that has not been reported.

Cathode luminescence (CL) measurement was conducted for the needle-like crystals 25 of GaN manufactured by Examples 1 to 9. The emission was observed in the wavelength range same as the above result.

### (Example 10) <Growth Example 1 of Seed Crystal>

In the present embodiment, the needle-like crystal having a length of 20 mm and a width of 500 µm was used as the seed crystal to grow the gallium nitride crystal. Thus, GaN crystal 80 was obtained. In this Example, the crystal growth was conducted by means of the crystal growth apparatus 1 shown in FIG. 4.

Firstly, the pressure resistant vessel 11 was separated from the crystal growth apparatus 1 at the valve 21 portion and put into the glove box under Ar atmosphere. Then, the seed crystal was installed into the rector vessel 12 made of sintered BN and having an inner diameter of 55 mm. Incidentally, the seed crystal was retained by inserting it to a hole which was made at the bottom of the reactor vessel 12 and had a depth of 4 mm. Then, sodium (Na) was heated and liquefied to be put into the reactor vessel 12. After the sodium was solidified, gallium (Ga) was put in. In this Example, the mol ratio of gallium to sodium was 0.4 : 0.6.

Then, in the glove box, the reactor vessel 12 was placed into the pressure resistant vessel 11 under a high purity Ar gas atmosphere. Then, the valve 21 was closed to seal the pressure resistant vessel 11 filled with Ar gas, so that the inner space of the reactor vessel 12 was shut out from the outer atmosphere.

Then, the pressure resistant vessel 11 was taken out from the glove box and assembled into the crystal growth apparatus 1. Namely, the pressure resistant vessel 11 was installed at a predetermined position with respect to the heater 13 and connected to the gas supplying pipe 14 at the valve 21 portion.

Then, the valve 21 and the valve 18 were opened, Ar gas was introduced from the diluent gas supplying pipe 20 and subjected to the pressure control by the pressure regulator 19 so that the whole pressure inside of the pressure resistant vessel 11 became 0.75 MPa. Then, the valve 18 was closed.

Then, the nitrogen gas was introduced from the nitrogen supplying pipe 17 and subjected to the pressure control by the pressure regulator 16. Then the valve 15 was opened so that the whole pressure inside of the pressure resistant vessel 11 became 3.3 MPa. Namely, the nitrogen partial pressure of the inner space 23 of the pressure resistant vessel 11 was 2.25 MPa. Then, the valve 15 was closed, and the pressure regulator 16 was set at 8MPa.

Next, the heater 13 was turned on to heat the reactor vessel 12 to the crystal growth temperature. The crystal growth temperature was 900 degrees Celsius. The whole pressure inside of the pressure resistant vessel 11 at 900 degrees Celsius was measured as 8 MPa by the pressure meter 22. Therefore, the nitrogen partial pressure inside of the pressure resistant vessel 11 at 900 degrees Celsius was 6 MPa.

Then, similarly to the operation of Example 1, the valve 15 was opened so that the nitrogen gas pressure became 8 MPa. The reactor vessel 12 was retained under this state for 1000 hours to grow the gallium nitride crystal.

As a result, in the reactor vessel 12, the crystal diameter of the needle-like crystal of GaN as the seed crystal increased toward a direction orthogonal to the c-axis to form a GaN crystal 80 having a larger crystal diameter (see FIG. 4). The grown part GaN crystal 27 was colorless and transparent. The crystal diameter of the GaN crystal 80 was 20 mm. The length of the GaN 80 was 47 mm. M-planes were formed on the side surfaces of the GaN crystal 80.

After cutting out and polishing the c-plane of the GaN crystal 80, the c-plane was etched by the acidic solution. Only a few etch pits were observed. In comparison with the conventional GaN crystal grown from the needle-crystal of AlN as the seed crystal, the GaN crystal 80 has remarkably less dislocation and was high quality.

As apparent from FIG. 10, it is preferable that conditions for conducting the crystal manufacturing method are arranged so that the mol ratio of gallium to sodium is 0.4 : 0.6, the nitrogen partial pressure is 6 MPa, and the crystal growth temperature is 900 degrees Celsius. Under these conditions, it is possible to produce a larger sized and high quality GaN crystal.

### (Example 11) <Growth Example 2 of Seed Crystal>

In this Example, the needle-like crystal having a length of 9 mm and a width of 300 µm was used as the seed crystal 25 to grow the gallium nitride crystal. Thus, GaN crystal 80 was obtained. In this Example, the crystal growth was conducted by means of the crystal growth apparatus 1 shown in FIG. 4. As the reactor vessel 12, a vessel made of a sintered BN and having an inner diameter of 23 mm and a depth of 30 mm was used.

The mol ratio of gallium to sodium was 0.5 : 0.5. The crystal growth temperature was 885 degrees Celsius. The nitrogen partial pressure was 6 MPa (whole pressure was 8 MPa). The crystal growth time was 200 hours. (Incidentally, inside of the pressure resistant vessel 11 at a room temperature before raising the temperature, the whole pressure was 3.1 MPa, the nitrogen partial pressure was 2.32 MPa, and Ar partial pressure was 0.78 MPa.)

As a result, in the reactor vessel 12, the crystal 27 grew so that the crystal diameter d of the seed crystal 25 increased toward a direction orthogonal to the c-axis to form a GaN crystal 80 having a larger crystal diameter (see FIG. 5). The crystal diameter d of the GaN crystal 80 was 0.6 mm. The length of the GaN 80 including the portion inserted to the reactor vessel 12 was 9 mm. M-planes were formed on the side surfaces of the GaN crystal 80.

By the way, when a plurality of crystal planes having different plane orientations grow simultaneously, a plurality of growth sectors may be formed by growing toward different crystal growth directions. Incidentally, a boundary interface between adjacent growth sectors is called a growth sector boundary. In these growth sectors, the optical property of each sector may differ. Also in the growth sector boundary, any impurity or defect may be segregated, or any distortion may arise in the crystal structure, and thereby the optical property such as reflectance, absorptance, transmittance, refractive index and so on may differ from other crystal part, so that the growth sector boundary may be clearly observed.

When the crystal growth rate changes during the crystal growth, a generation amount of defects or a solid solution amount of impurities may change, and growth striation may be formed on a face along a specific crystal plane. Such a growth striation may be clearly observed depending on the difference in the optical property such as reflectance, absorptance, transmittance, refractive index and so on, or the coloring due to impurities, and the like.

However, in this Example, the crystal 27 which is a grown crystal part was colorless and transparent. The growth sector boundary or other growth striation was not observed in the crystal 27.

Next, the side surface (m-plane) and the cross section of the GaN crystal 80 were observed by means of a fluorescent microscope. As a light source of the fluorescent microscope, a light source having a wavelength of 320 to 400 nm and a peak wavelength of 370 nm was used. As the fluorescent image, the fluorescent image whose wavelength is 420 nm or more (□420 nm) was observed through a filter.

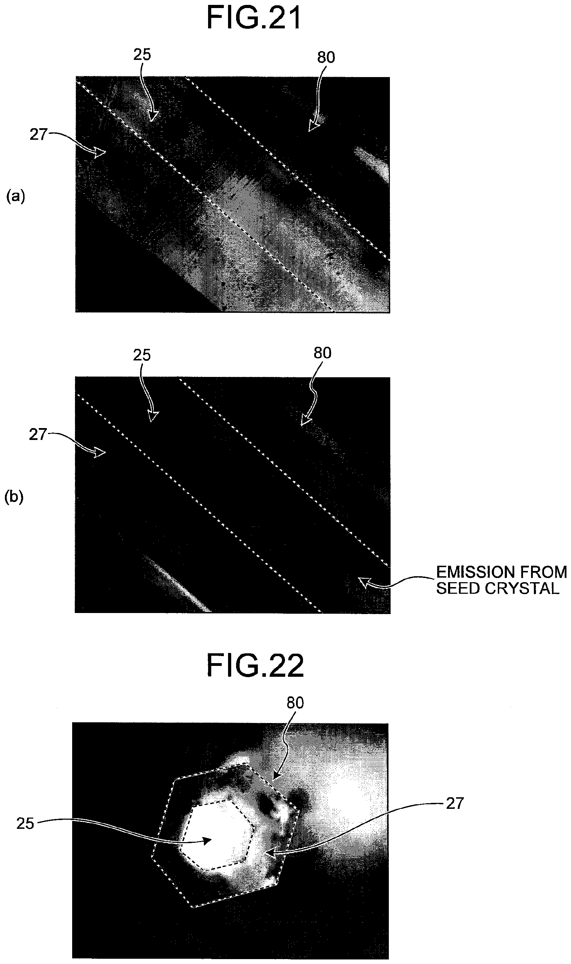

FIG. 21 shows a micrograph (a) of the side surface (m-plane) of the GaN crystal 80 manufactured by Example 11, and a fluorescent image (b) of the same position as (a). Incidentally, a visible light was used as the light source of (a). As shown in FIG. 21(a), in the side surface (m-plane) of the GaN crystal 80, a flat crystal surface was observed. As shown in FIG. 21(b), an electron state of the seed crystal 25 was excited by ultraviolet light (320 to 400 nm), and an orange emission was observed from the seed crystal 25. Incidentally, any visible emission was not observed from the crystal 27 grown around the seed crystal 25.

FIG. 22 is a fluorescent image of a cross section (c-plane) of the GaN crystal 80. As shown in FIG. 22, the hexagonal seed crystal 25 inside of the GaN crystal 80 was observed as orange emission. In the crystal 27 grown around the seed crystal 25, any clear growth sector boundary or growth striation was not observed inside of the crystal 27, and it was observed that a light from the seed crystal 25 is waveguided in the colorless and transparent crystal.

Next, a photoluminescence of the c-plane of the GaN crystal 80 was measured at a room temperature. As an exciting light source, He-Cd laser having a wavelength of 325 nm was used. In the photoluminescence spectrum of the seed crystal 25, an emission from the vicinity of the band edge of gallium nitride (around 364 nm) and an emission approximately from 500 nm to 800 nm and having the peak intensity of 625 nm (600 nm to 650 nm) were observed. The broad emission from 500 nm to 800 nm was stronger than the emission from the vicinity of the band edge.

On the other hand, in the photoluminescence spectrum of the crystal 27 grown around the seed crystal 25, although a strong emission from the vicinity of the band edge of gallium nitride (around 364 nm) was observed, any broad emission from 500 nm to 800 nm was not observed.

### (Example 12) <Growth Example 3 of Seed Crystal>

In this Example, the needle-like crystal having a length of 20 mm and a width of 500 µm was used as the seed crystal 25 to grow the gallium nitride crystal. Thus, GaN crystal 80 was obtained. In this Example, the crystal growth was conducted by means of the crystal growth apparatus 1 shown in FIG. 4. As the reactor vessel 12, a vessel made of a sintered BN and having an inner diameter of 55 mm and a depth of 60 mm was used.

The mol ratio of gallium to sodium was 0.4 : 0.6. The crystal growth temperature was 900 degrees Celsius. The nitrogen partial pressure was 6 MPa (whole pressure was 8 MPa). The crystal growth time was 1000 hours. (Incidentally, inside of the pressure resistant vessel 11 at a room temperature before raising the temperature, the whole pressure was 3 MPa, the nitrogen partial pressure was 2.25 MPa, and Ar partial pressure was 0.75 MPa.)

As a result, in the reactor vessel 12, the crystal 27 grew so that the crystal diameter d of the seed crystal 25 increased toward a direction orthogonal to the c-axis to form a GaN crystal 80 having a larger crystal diameter (see FIG. 5). The crystal diameter d of the GaN crystal 80 was 20 mm. The length of the GaN 80 was 47 mm. M-planes were formed on the side surfaces of the GaN crystal 80. The crystal 27 which is a grown crystal part was colorless and transparent.

The c-plane of the GaN crystal 80 was cut out and polished. Then the c-plane was etched by the acidic solution and observed. Only a few etch pits were observed. In comparison with GaN crystal grown from a needle-like crystal of aluminum nitride by the conventional crystal manufacturing method, it was confirmed that the crystal of this Example was high quality with much less dislocation.

Next, a photoluminescence of the cut out c-plane of the GaN crystal 80 was measured at a room temperature. As an exciting light source, He-Cd laser having a wavelength of 325 nm was used. In the photoluminescence spectrum of the seed crystal 25, an emission from the vicinity of the band edge of gallium nitride (around 364 nm) and an emission approximately from 500 nm to 800 nm and having the peak intensity of 625 nm (600 nm to 650 nm) were observed. The broad emission from 500 nm to 800 nm was stronger than the emission from the vicinity of the band edge.

On the other hand, in the photoluminescence spectrum of the crystal 27 grown around the seed crystal 25, although a strong emission from the vicinity of the band edge of gallium nitride (around 364 nm) was observed, any broad emission from 500 nm to 800 nm was not observed.

### (Example 13) <Growth Example 4 of Seed Crystal>

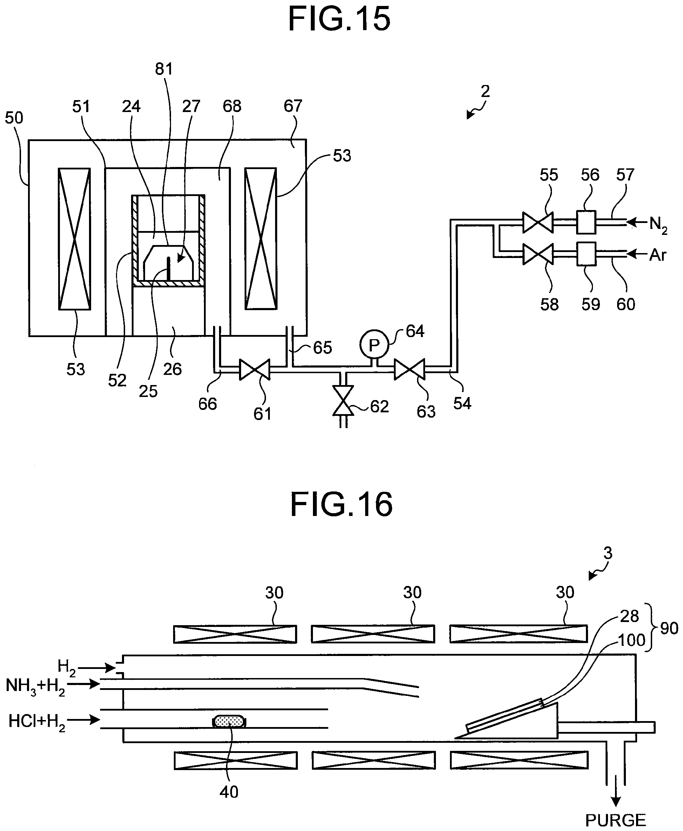

In this Example, GaN crystal 81 was manufactured by conducting a crystal growth process from the seed crystal 25 by means of the crystal growth apparatus 2 shown in FIG. 15. FIG. 15 is a schematic view (cross section) illustrating an exemplary configuration of the crystal growth apparatus used in Example 13. The crystal growth apparatus 2 of this Example has a double structure in which an inner pressure resistant vessel 51 is disposed in an outer pressure resistant vessel 50 made of stainless material, and a reactor vessel 52 is accommodated in the inner pressure resistant vessel 51.

In the outer pressure resistant vessel 50, a heater 53 was disposed to heat a molten mixture 24 in the reactor vessel 52. The inner pressure resistant vessel 51 is made of stainless material and has a closed shape, and can be detached from the outer pressure resistant vessel 50. In the inner pressure resistant vessel 51, there is disposed the reactor vessel 52 to retain the molten mixture 24 containing the metal sodium and gallium and conduct the crystal growth.

In this Example, the reactor vessel 52 made of YAG, and having the inner diameter of 92 mm and the depth of 60 mm was used. Incidentally, the material of the rector vessel 52 is not limited to any particular one. Nitrides such as sintered BN, P-BN and the like, oxides such as alumina, YAG and the like, carbides such as SiC and the like may be used.

Hereinafter, an explanation will be made on a growth method of GaN crystal by means of the crystal growth apparatus 2. Firstly, the inner pressure resistant vessel 51 was detached from the crystal growth apparatus 2 at the valve 61 portion, and was put into a glove box under Ar atmosphere.

Next, the seed crystal 25 was installed in the reactor vessel 52. In this Example, as the seed crystal 25, the needle-like crystal having the width of 500 µm and the length of 20 mm was used. Incidentally, the seed crystal 25 was retained by inserting it to a hole which was made at the bottom of the reactor vessel 52 and had a depth of 4 mm.

Then, metal sodium (Na) was heated and liquefied to be put into the reactor vessel 52. After the sodium was solidified, gallium was put in. In this Example, the mol ratio of gallium to sodium was 0.3 : 0.7.

Then, in the glove box, the reactor vessel 52 was placed into the inner pressure resistant vessel 51 under a high purity Ar gas atmosphere. Then, the valve 61 was closed to seal the inner pressure resistant vessel 51 filled with Ar gas, so that the inner space of the reactor vessel 52 was shut out from the outer atmosphere.

Then, the pressure resistant vessel 51 was taken out from the glove box and assembled into the crystal growth apparatus 2. Namely, the inner pressure resistant vessel 51 was installed at a predetermined position of the outer pressure resistant vessel 50 and connected to the gas supplying pipe 54 at the valve 61 portion. By installing the inner pressure resistant vessel 51 to the outer pressure resistant vessel 50, an inside of the outer pressure resistant vessel 50 is shut out from the outer atmosphere.

Then, a nitrogen introduction and a vacuuming inside of the outer pressure resistant vessel 50 and inside of piping between the valve 61 and the valve 63 was repeated 10 times via the valve 62. Incidentally, the valve 63 was closed in advance. Then, the valve 62 was closed and the valves 61, 63 and 58 were opened to introduce Ar gas from a gas supplying pipe 60 for controlling the whole pressure. The pressure of Ar gas was controlled by a pressure regulator 59 so that the whole pressure inside of the outer pressure resistant vessel 50 and inside of the inner pressure resistant vessel 51 became 1.5 MPa. Then, the valve 58 was closed.

Then, the nitrogen gas was introduced from a nitrogen supplying pipe 57 and subjected to a pressure control by a pressure regulator 56, so that the whole pressure inside of the outer pressure resistant vessel 50 and inside of the inner pressure resistant vessel 51 became 3.4 MPa. Namely, the nitrogen partial pressure of the inner space 67 of the outer pressure resistant vessel 50 and the inner space 68 of the inner pressure resistant vessel 51 was 1.9 MPa. Then, the valve 55 was closed, and the pressure regulator 56 was set at 8MPa.

Next, the heater 53 was turned on to heat the reactor vessel 52 to a crystal growth temperature. The crystal growth temperature was 900 degrees Celsius. The whole pressure inside of the outer pressure resistant vessel 50 and inside of the inner pressure resistant vessel 51 at 900 degrees Celsius was measured as 8 MPa by the pressure meter 64. Therefore, the nitrogen partial pressure inside of the outer pressure resistant vessel 50 and inside of the inner pressure resistant vessel 51 at 900 degrees Celsius was 4.47 MPa.

Then, the valve 55 was opened so that the nitrogen gas pressure became 8 MPa. The reactor vessel 52 was retained under this state for 2000 hours to grow the GaN crystal 27. By applying 8 MPa of nitrogen gas pressure, the nitrogen consumed for the crystal growth can be supplied and the nitrogen partial pressure can be always maintained constant.

As a result, in the reactor vessel 52, the crystal 27 grew so that the crystal diameter d of the seed crystal increased toward a direction orthogonal to the c-axis to form a GaN crystal 81 having a larger crystal diameter d (see FIG. 6). The crystal diameter d of GaN crystal 81 was 60 mm, and the length was about 35 mm including a seed crystal 25 portion inserted to the reactor vessel 52. As shown in FIG. 6, a top face of GaN crystal 81 was a c-plane with asperity, and m-planes were formed on side surfaces. At upper outer periphery of GaN crystal 81, gentle slope faces connecting the c-plane and m-planes were formed. The seed crystal 25 is contained at almost center portion in GaN crystal 81.

### (Example 14) <Manufacturing Example of Crystal Substrate>

In this Example, a cutting process to cut out the GaN crystal 81 manufactured by Example 13 was conducted to produce a crystal substrate 100a. Namely, the outline of GaN crystal 81 (see FIG. 6) was ground and the GaN crystal 81 was sliced parallel to the c-plane as shown in FIG. 7-2. Then, the surface polishing and other surface treatment were conducted, so that the crystal substrate 100a (see FIG. 8-1) of GaN having c-plane as main face and having a thickness of 400 µm and a diameter ϕ of 2 inches was produced.

The main face (c-plane) of the substrate was etched by acidic solution (mixed acid of phosphorus acid and sulfuric acid, 230 degrees Celsius) to evaluate the etch pit density. The etch pit density was in the order of 10² cm⁻². In comparison with GaN crystal grown from a needle-like crystal of aluminum nitride by the conventional crystal manufacturing method, it was confirmed that the crystal of this Example was high quality with much less dislocation.

Next, a photoluminescence of the crystal substrate 100a was measured at a room temperature. As an exciting light source, He-Cd laser having a wavelength of 325 nm was used. In the photoluminescence spectrum of the seed crystal 25, an emission from the vicinity of the band edge of gallium nitride (around 364 nm) and an emission approximately from 500 nm to 800 nm and having the peak intensity of 625 nm (600 nm to 650 nm) were observed. The broad emission from 500 nm to 800 nm was stronger than the emission from the vicinity of the band edge.

On the other hand, in the photoluminescence spectrum of the crystal 27 grown around the seed crystal 25, although a strong emission from the vicinity of the band edge of gallium nitride (around 364 nm) was observed, any broad emission from 500 nm to 800 nm was not observed.

### (Example 15) <Crystal Manufacturing Example employing HVPE Method and Manufacturing Example of Crystal Substrate>

In this Example, an epitaxial growth process according to a HVPE method was conducted to epitaxially grow GaN crystal 28 by 1 mm on the GaN crystal substrate 100a produced by Example 14, so that GaN crystal 90 was produced as shown in FIG. 11-1. And, GaN crystal substrate 101 (see FIG. 11-2) was produced from the GaN crystal 90.

Now, an explanation will be made on the epitaxial growth process according to the HVPE method with reference to FIG. 16. FIG. 16 is a schematic view (cross section) illustrating an exemplary configuration of a crystal growth apparatus 3 used in this Example. As shown in FIG. 16, various kinds of gas can be introduced into a reactor vessel of the crystal growth apparatus 3. A heater 30 to heat inside of the apparatus is disposed around the outer periphery of the reactor vessel.

In the crystal growth according to the HVPE method of this Example, hydrogen was used as carrier gas. Gallium chloride gas obtained by reacting gallium 40 with hydrogen chloride gas at 900 degrees Celsius was carried onto the GaN crystal substrate 100 (100a) heated to 1100 degrees Celsius and reacted with ammonia gas to grow GaN crystal 28 on the GaN crystal substrate 100 (100a), so that GaN crystal 90 (see FIG. 11-1) was obtained.

Then, after treating an outer diameter of produced GaN crystal 90, substrate treatments such as polishing, surface treatment and the like were conducted, so that GaN crystal substrate 101 (101a) having a diameter of 2 inches was produced (see FIG. 11-2, and see FIG. 14-1).

### (Example 16) <Crystal Manufacturing Example employing Flux Method and Manufacturing Example of Crystal Substrate>

In this Example, an epitaxial growth process according to a flux method was conducted to grow GaN crystal 28 on the GaN crystal substrate 100a produced by Example 14, so that GaN crystal 90 was produced as shown in FIG. 11-1. And, GaN crystal substrate 101 (see FIG. 11-2 and see FIG. 14-1) and GaN crystal substrates 28b1 to 28b6 (see FIG. 11-3) were produced from the GaN crystal 90.

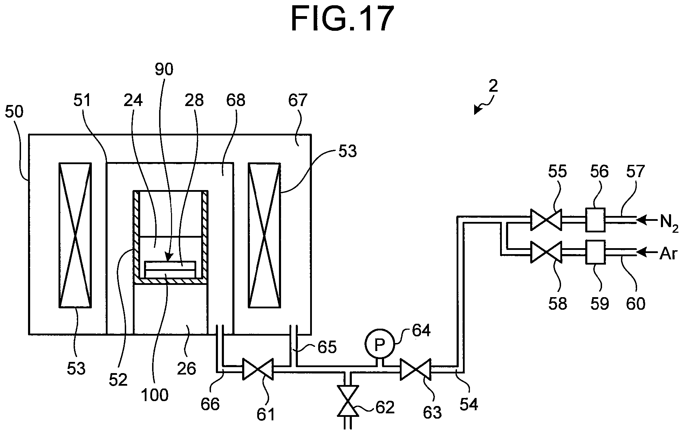

Now, an explanation will be made on the epitaxial growth process according to the flux method with reference to FIG. 17. FIG. 17 is a schematic view (cross section) illustrating an exemplary configuration of the crystal growth apparatus 2 used in this Example. The crystal growth apparatus 2 of this Example was the same as that shown in FIG. 15 and the explanation will be omitted.

In this Example, the mol ratio of gallium to sodium to be put into the reactor vessel 52 was 0.25 : 0.75. The crystal growth temperature was 880 degrees Celsius. The nitrogen partial pressure was 4 MPa (whole pressure was 8 MPa). The crystal growth time was 1000 hours. (Incidentally, in the inner spaces 67, 68 at a room temperature before raising the temperature, the whole pressure was 3.6 MPa, the nitrogen partial pressure was 1.8 MPa, and Ar partial pressure was 1.8 MPa.)

As a result, GaN crystal 28 having c-plane as main face was grown on GaN 100, so that GaN crystal 90 as shown in FIG. 11-1 was obtained. A thickness of GaN crystal 28 was 10 mm and a diameter was slightly larger than the diameter (ϕ2 inches) of the GaN crystal substrate 100 (100a).

Then, an outer diameter of GaN crystal 90 was treated. As shown in FIG. 11-2, the GaN crystal 90 was sliced parallel to the c-plane, so that GaN crystal substrate 101 was separated from GaN crystal 28 grown on the GaN crystal substrate 100. Then, the GaN crystal 28b was further sliced as shown in FIG. 11-3 into GaN crystal substrates 28b1 to 28b6 each having a diameter of 2 inches. Each of sliced crystal substrates is subjected to polishing, surface treatment and the like.

Thus, in this Example, the GaN crystal substrates 101 and 28b1 to 28b6 each having a large area with approximately 2 inch diameter can be produced. A plurality of GaN crystal substrates can be produced from the high quality GaN crystal 90.

### Reference Signs List

1,2,3 Crystal Growth Apparatus
11 Pressure Resistant Vessel
12,52 Reactor Vessel
13, 30, 53 Heater
14, 54, 65, 66 Gas Supplying Pipe
15, 18, 21, 55, 58, 61, 62, 63 Valve
16, 19, 56, 59 Pressure Regulator
17, 57 Nitrogen Supplying Pipe
20, 60 Diluent Gas Supplying Pipe
22, 64 Pressure Meter
23 Inner Space of Pressure Resistant Vessel
24 Molten Mixture
25 Needle-like Crystal (Seed Crystal)
26 Pedestal
27, 28, 80, 81, 82, 83, 90, 91, 92 Group 13 Nitride Crystal (GaN Crystal) 40 Gallium
50 Outer Pressure Resistant Vessel
51 Inner Pressure Resistant Vessel
67 Inner Space of Outer Pressure Resistant Vessel
68 Inner Space of Inner Pressure Resistant Vessel 100, 101 Group 13 Nitride Crystal Substrate (GaN Crystal Substrate)

### Citation List

### Patent Literature

Patent Literature 1: Japanese Patent Application Laid-open No. 2008-94704.
Patent Document 2: Japanese Patent Application Laid-open No. 2006-045047.

## Claims

1. A method of manufacturing a gallium nitride crystal having an hexagonal shaped or an almost hexagonal shaped cross section orthogonal to the c-axis, a length L of the c-axis of 9 mm or more, and a ratio L/d of the length L of the c-axis to the crystal diameter d of the cross section orthogonal to the c-axis of 7 or more, **characterized in that** the method includes:
a molten mixture forming process to form a molten mixture containing at least sodium and gallium in a reactor vessel, bring gas containing nitrogen into contact with the molten mixture, and dissolve the nitrogen from the gas into the molten mixture; and
a crystal growth process to grow the gallium nitride crystal toward -c-axis direction of the crystal from the gallium in the molten mixture and the nitrogen dissolved in the molten mixture, wherein
in the molten mixture forming process, a mol ratio of sodium to a total amount of gallium and sodium in the molten mixture is in a range of 75 % to 90 %, a temperature of the molten mixture is in a range of 860 degrees Celsius to 900 degrees Celsius, and a nitrogen partial pressure of the gas is in a range of 5 MPa to 8 MPa.

2. The method of manufacturing the gallium nitride crystal according to claim 1, **characterized in that** a portion of the reactor vessel coming into contact with the molten mixture is made of sintered BN (boron nitride).

3. A method of manufacturing a group 13 nitride crystal comprising:
manufacturing a gallium nitride crystal by performing the method of claim 1 or claim 2;
a process to install the gallium nitride crystal as a seed crystal into a reactor vessel;
a molten mixture forming process to form a molten mixture of alkali metal with material containing at least a group 13 element in a reactor vessel, bring gas containing nitrogen into contact with the molten mixture, and dissolve the nitrogen from the gas into the molten mixture; and
a crystal growth process to grow the seed crystal toward a direction orthogonal to the c-axis from the group 13 element in the molten mixture and the nitrogen dissolved in the molten mixture.

4. A method of manufacturing a crystal substrate from a group 13 nitride crystal, comprising
manufacturing a group 13 nitride crystal by performing the method of claim 3; and
a process to cut out the group 13 nitride crystal so as to contain at least a part of the gallium nitride crystal.

5. A method of manufacturing a group 13 nitride crystal, comprising:
manufacturing a crystal substrate by performing the method of claim 4: and
a process to epitaxially grow a group 13 nitride crystal on at least one main face of the crystal substrate.

6. A method of manufacturing a crystal substrate from a group 13 nitride crystal, comprising:
manufacturing a group 13 nitride crystal by performing the method of claim 3; and
a process to cut out the group 13 nitride crystal so as not to contain the gallium nitride crystal.

7. The method of manufacturing a group 13 nitride crystal according to claim 5, wherein the process to epitaxially grow the group 13 nitride crystal includes:
a process to install the crystal substrate into the reactor vessel;
a molten mixture forming process to form a molten mixture of alkali metal with material containing at least group 13 element in a reactor vessel, bring gas containing nitrogen into contact with the molten mixture, and dissolve the nitrogen from the gas into the molten mixture; and
a crystal growth process to grow the 13 group nitride crystal on the crystal substrate from the group 13 element in the molten mixture and the nitrogen dissolved in the molten mixture.

8. The method of manufacturing a group 13 nitride crystal according to claim 3 or 7, wherein a mol ratio of the alkali metal to a total amount of the group 13 element and the alkali metal in the molten mixture is in a range of 40% to 95 %, a temperature of the molten mixture is at least 700 degrees Celsius or more, and a nitrogen partial pressure of the gas is at least 0.1 MPa or more.

9. The method of manufacturing the group 13 nitride crystal according to any of claims 3, 5 and 7, wherein the alkali metal is sodium, the group 13 element is gallium, and a gallium nitride crystal is grown as the group 13 nitride crystal.

## Patentansprüche

1. Verfahren zur Herstellung eines Galliumnitridkristalls mit einem hexagonal geformten oder einem fast hexagonal geformten Querschnitt, der orthogonal zu der c-Achse ist, einer Länge L der c-Achse von 9 mm oder mehr und einem Verhältnis L/d der Länge L der c-Achse zu dem Kristalldurchmesser d des Querschnitts, der orthogonal zu der c-Achse von 7 oder mehr ist, **dadurch gekennzeichnet, dass** das Verfahren Folgendes beinhaltet:
ein geschmolzenes Mischungsbildungsverfahren, um eine geschmolzene Mischung zu bilden, die mindestens Natrium und Gallium in einem Reaktorgefäß enthält, um Stickstoff enthaltendes Gas in Kontakt mit der geschmolzenen Mischung zu bringen und um den Stickstoff aus dem Gas in der geschmolzenen Mischung aufzulösen; und
ein Kristallzüchtungsverfahren zum Züchten des Galliumnitridkristalls zu der -c-Achsenrichtung des Kristalls aus dem Gallium in der geschmolzenen Mischung und dem in der geschmolzenen Mischung aufgelösten Stickstoff, wobei
in dem geschmolzenen Mischungsbildungsverfahren ein Molverhältnis von Natrium zu einer Gesamtmenge von Gallium und Natrium in der geschmolzenen Mischung in einem Bereich von 75 % bis 90 % ist, eine Temperatur der geschmolzenen Mischung in einem Bereich von 860 Grad Celsius bis 900 Grad Celsius ist und ein Stickstoffpartialdruck des Gases in einem Bereich von 5 MPa bis 8 MPa ist.

2. Verfahren zur Herstellung des Galliumnitridkristalls nach Anspruch 1, **dadurch gekennzeichnet, dass** ein Abschnitt des Reaktorgefäßes, der in Kontakt mit der geschmolzenen Mischung kommt, aus gesintertem BN (Bornitrid) besteht.

3. Verfahren zur Herstellung eines Gruppe-13-Nitridkristalls, umfassend:
Herstellen eines Galliumnitridkristalls durch Durchführen des Verfahrens nach Anspruch 1 oder Anspruch 2;
ein Verfahren zum Einbringen des Galliumnitridkristalls als einen Impfkristall in ein Reaktorgefäß;
ein geschmolzenes Mischungsbildungsverfahren, um eine geschmolzene Mischung aus Alkalimetall mit Material zu bilden, das mindestens ein Gruppe-13-Element in einem Reaktorgefäß enthält, um ein Stickstoff enthaltendes Gas in Kontakt mit der geschmolzenen Mischung zu bringen und um den Stickstoff aus dem Gas in der geschmolzenen Mischung aufzulösen; und
ein Kristallzüchtungsverfahren zum Züchten des Impfkristalls zu einer Richtung, die orthogonal zu der c-Achse von dem Gruppe-13-Element in der geschmolzenen Mischung und dem in der geschmolzenen Mischung aufgelösten Stickstoff ist.

4. Verfahren zur Herstellung eines Kristallsubstrats aus einem Gruppe-13-Nitridkristall, umfassend
Herstellen eines Gruppe-13-Nitridikristalls durch Durchführen des Verfahrens nach Anspruch 3; und
ein Verfahren zum Ausschneiden des Gruppe-13-Nitridkristalls, um mindestens einen Teil des Galliumnitridkristalls zu enthalten.

5. Verfahren zur Herstellung eines Gruppe-13-Nitridkristalls, umfassend:
Herstellen eines Kristallsubstrats durch Durchführen des Verfahrens nach Anspruch 4; und
ein Verfahren zum epitaktischen Züchten eines Gruppe-13-Nitridkristalls auf mindestens einer Hauptfläche des Kristallsubstrats.

6. Verfahren zur Herstellung eines Kristallsubstrats aus einem Gruppe-13-Nitridkristall, umfassend:
Herstellen eines Gruppe-13-Nitridkristalls durch Durchführen des Verfahrens nach Anspruch 3; und
ein Verfahren zum Ausschneiden des Gruppe-13-Nitridkristalls, um nicht den Galliumnitridkristall zu enthalten.

7. Verfahren zur Herstellung eines Gruppe-13-Nitridkristalls nach Anspruch 5, wobei das Verfahren zum epitaktischen Züchten des Gruppe-13-Nitridkristalls Folgendes beinhaltet:
ein Verfahren zum Einbringen des Kristallsubstrats in das Reaktorgefäß;
ein geschmolzenes Mischungsbildungsverfahren, um eine geschmolzene Mischung aus Alkalimetall mit Material zu bilden, das mindestens ein Gruppe-13-Element in einem Reaktorgefäß enthält, um Stickstoff enthaltendes Gas in Kontakt mit der geschmolzenen Mischung zu bringen und um Stickstoff aus dem Gas in der geschmolzenen Mischung aufzulösen; und
ein Kristallzüchtungsverfahren zum Züchten des Gruppe-13-Nitridkristalls auf dem Kristallsubstrat aus dem Gruppe-13-Element in der geschmolzenen Mischung und dem in der geschmolzenen Mischung aufgelösten Stickstoff.

8. Verfahren zur Herstellung eines Gruppe-13-Nitridkristalls nach Anspruch 3 oder 7, wobei ein Molverhältnis des Alkalimetalls zu einer Gesamtmenge des Gruppe-13-Elements und des Alkalimetalls in der geschmolzenen Mischung in einem Bereich von 40 % bis 95 % ist, eine Temperatur der geschmolzenen Mischung mindestens 700 Grad Celsius oder mehr ist und ein Stickstoffpartialdruck des Gases mindestens 0,1 MPa oder mehr ist.

9. Verfahren zur Herstellung des Gruppe-13-Nitridkristalls nach einem der Ansprüche 3, 5 und 7, wobei das Alkalimetall Natrium ist, das Gruppe-13-Element Gallium ist und ein Galliumnitridkristall als der Gruppe-13-Nitridkristall gezüchtet ist.

## Revendications

1. Procédé de production d'un cristal de nitrure de gallium présentant une forme hexagonale ou une section transversale de forme presque hexagonale perpendiculaire à l'axe c, une longueur L de l'axe c de 9 mm ou plus et un rapport L/d de la longueur L de l'axe c au diamètre de cristal d de la section transversale perpendiculaire à l'axe c de 7 ou plus, **caractérisé en ce que** le procédé comprend :
un processus de formation de mélange fondu pour former un mélange fondu contenant au moins du sodium et du gallium dans une cuve de réacteur, mettre un gaz contenant de l'azote en contact avec le mélange fondu et dissoudre l'azote issu du gaz dans le mélange fondu ; et
un processus de croissance de cristal pour faire croître le cristal de nitrure de gallium vers une direction de l'axe c du cristal issu du gallium dans le mélange fondu et de l'azote dissous dans le mélange fondu,
dans le processus de formation de mélange fondu, un rapport molaire de sodium à la quantité totale de gallium et de sodium dans le mélange fondu se situant dans une plage allant de 75 % à 90 %, une température du mélange fondu se situant dans une plage de 860 degrés Celsius à 900 degrés Celsius et une pression partielle d'azote du gaz se situant dans une plage allant de 5 MPa à 8 MPa.

2. Procédé de production du cristal de nitrure de gallium selon la revendication 1, **caractérisé en ce qu'**une partie de la cuve de réacteur venant en contact avec le mélange fondu est constituée de BN (nitrure de bore) fritté.

3. Procédé de production d'un cristal de nitrure du groupe 13 comprenant :
la production d'un cristal de nitrure de gallium par la réalisation du procédé selon la revendication 1 ou la revendication 2 ;
un processus d'installation du cristal de nitrure de gallium en tant que germe cristallin dans une cuve de réacteur ;
un processus de formation de mélange fondu pour former un mélange fondu de métal alcalin avec un matériau comprenant au moins un élément du groupe 13 dans une cuve de réacteur, mettre un gaz contenant de l'azote en contact avec le mélange fondu et dissoudre l'azote issu du gaz dans le mélange fondu ; et
un processus de croissance de cristal pour faire croître le germe cristallin vers une direction perpendiculaire à l'axe c à partir de l'élément du groupe 13 dans le mélange fondu et de l'azote dissous dans le mélange fondu.

4. Procédé de production d'un substrat de cristal à partir d'un cristal de nitrure du groupe 13, comprenant
la production d'un cristal de nitrure du groupe 13 par la réalisation du procédé selon la revendication 3 ; et
un processus de découpe du cristal de nitrure du groupe 13 de manière qu'il contienne au moins une partie du cristal de nitrure de gallium.

5. Procédé de production d'un cristal de nitrure du groupe 13, comprenant :
la production d'un substrat de cristal par la réalisation du procédé selon la revendication 4 ; et
un processus de croissance épitaxiale d'un cristal de nitrure du groupe 13 sur au moins une face principale du substrat de cristal.

6. Procédé de production d'un substrat de cristal à partir d'un cristal de nitrure du groupe 13, comprenant :
la production d'un cristal de nitrure du groupe 13 par la réalisation du procédé selon la revendication 3 ; et
un processus de découpe du cristal de nitrure du groupe 13 de manière qu'il contienne le cristal de nitrure de gallium.

7. Procédé de production d'un cristal de nitrure de groupe 13 selon la revendication 5, dans lequel le procédé de croissance épitaxiale du cristal de nitrure du groupe 13 comprend :
un processus d'installation du substrat de cristal dans la cuve de réacteur ;
un processus de formation de mélange fondu pour former un mélange fondu de métal alcalin avec un matériau contenant au moins un élément du groupe 13 dans une cuve de réacteur, mettre un gaz contenant de l'azote en contact avec le mélange fondu et dissoudre l'azote issu du gaz dans le mélange fondu ; et
un processus de croissance de cristal pour faire croître le cristal de nitrure du groupe 13 sur le substrat de cristal à partir de l'élément du groupe 13 dans le mélange fondu et de l'azote dissous dans le mélange fondu.

8. Procédé de production d'un cristal de nitrure du groupe 13 selon la revendication 3 ou 7, dans lequel un rapport molaire du métal alcalin à une quantité totale de l'élément du groupe 13 et du métal alcalin dans le mélange fondu se situe dans une plage de 40 % à 95 %, une température du mélange fondu est d'au moins 700 degrés Celsius ou plus et une pression partielle d'azote du gaz est d'au moins 0,1 MPa ou plus.

9. Procédé de production du cristal de nitrure du groupe 13 selon l'une quelconque des revendications 3, 5 et 7, dans lequel le métal alcalin est du sodium, l'élément du groupe 13 est du gallium et un cristal de nitrure de gallium est cultivé en tant que cristal de nitrure du groupe 13.
